# EUROPEAN PATENT APPLICATION

(11) **EP 4 842 184 A1**
(43) Date of publication of application: **18.11.2026**
(21) Application number: 26161154.5
(22) Date of filing: 26.02.2026
(51) Int. Cl.: H10P 72/00, H10P 74/00

(54) **MISALIGN DETECTION CIRCUIT AND METHOD OF OPERATING THE SAME**

(30) Priority: 24.04.2025 KR 20250053823; 03.02.2026 US 202619468457
(71) Applicant: Samsung Electronics Co., Ltd., Suwon-si, Gyeonggi-do 16677 (KR)
(72) Inventor: NAM, Bu-Il, 16677 Suwon-si (KR); LEE, Jaein, 16677 Suwon-si (KR); LEE, Jeong-Goo, 16677 Suwon-si (KR); JEONG, Jaeyong, 16677 Suwon-si (KR)
(74) Representative: Marks & Clerk LLP

(57) **Abstract**

A semiconductor device includes a first wafer including a first upper detection pad and a second upper detection pad, and a second wafer including a first lower detection pad and a second lower detection pad, the first wafer being bonded to the second wafer. When the first wafer and the second wafer are bonded together, the first upper and lower detection pads are spaced apart from each other by a first separation distance on the plane, and the second upper and lower detection pads are spaced apart from each other by a second separation distance on the plane different from the first separation distance. An alignment status of the first and second wafers is determined based on a current flowing when the first upper detection pad and the second upper detection pad and the first lower detection pad and the second lower detection pad are connected to each other.

## Description

### BACKGROUND

The present disclosure relates to a misalignment detection circuit, and more particularly, to the misalignment detecting circuit and a method for operating the same.

Wafer-to-wafer bonding is a process used to fabricate a semiconductor device. Specifically, wafer-to-wafer bonding is a process in which two semiconductor wafers are aligned and then bonded together. When the two wafers are not aligned, performance of an operation of writing data to the memory cell array or reading the written data may be degraded. Therefore, it is advantageous to detect misalignment when performing the wafer-to-wafer process.

### SUMMARY

It is an aspect to provide a misalignment detection circuit having improved performance and improved reliability, and a method for operating the same.

According to an aspect of one or more embodiments, a semiconductor device may comprise a first wafer including a first upper detection pad and a second upper detection pad; and a second wafer including a first lower detection pad and a second lower detection pad, the first wafer being bonded to the second wafer. When the first wafer and the second wafer are bonded on a plane formed by the first wafer and the second wafer, the first upper detection pad and the first lower detection pad are spaced apart from each other by a first separation distance on the plane, and the second upper detection pad and the second lower detection pad are spaced apart from each other by a second separation distance on the plane, the second separation distance being different from the first separation distance. An alignment status between the first wafer and the second wafer may be determined based on a current flowing when the first upper detection pad and the second upper detection pad and the first lower detection pad and the second lower detection pad are connected to each other.

According to another aspect of one or more embodiments, a semiconductor device may comprise a first wafer including a first upper detection pad, a second upper detection pad, a third upper detection pad, and a fourth upper detection pad; and a second wafer including a first lower detection pad, a second lower upper detection pad, a third lower detection pad, and a fourth lower detection pad. The first wafer may be bonded to the second wafer. When the first wafer and the second wafer are bonded on a plane formed by the first wafer and the second wafer, the first upper detection pad is spaced apart from the first lower detection pad by a first separation distance, the second upper detection pad is spaced apart from the second lower detection pad by a second separation distance that is different from the first separation distance, the third upper detection pad is spaced apart from the third lower detection pad by the first separation distance, and the fourth upper detection pad is spaced apart from the fourth lower detection pad by the second separation distance. The first lower detection pad is disposed in a first direction from the first upper detection pad, the second lower detection pad is disposed in the first direction from the second upper detection pad, the third lower detection pad is disposed in a second direction from the third upper detection pad, the second direction different from the first direction, the fourth lower detection pad is disposed in the second direction from the fourth upper detection pad, and an aligned status between the first wafer and the second wafer may be determined based on a current flowing when the first upper detection pad, the second upper detection pad, the third upper detection pad, and the fourth upper detection pad are connected to the first lower detection pad, the second lower detection pad, the third lower detection pad, and the fourth lower detection pad .

According to yet another aspect of one or more embodiments, a method for manufacturing a semiconductor device may comprise bonding a first wafer and a second wafer, the first wafer including a first upper detection pad and a second upper detection pad, and the second wafer including a first lower detection pad and a second lower detection pad; measuring a first current flowing between the first upper detection pad and the first lower detection pad; measuring a second current flowing between the second upper detection pad and the second lower detection pad; determining whether a first magnitude of the first current is greater than or equal to a reference magnitude; determining whether a second magnitude of the second current is greater than or equal to the reference magnitude; and determining an aligned status of the first wafer and the second wafer based on the first magnitude and the second magnitude. When the first wafer and the second wafer are bonded on a plane formed by the first wafer and the second wafer, the first upper detection pad is spaced apart from the first lower detection pad by a first separation distance, and the second upper detection pad is spaced apart from the second lower detection pad by a second separation distance that is different from the first separation distance.

At least some of the above and other features of the invention are set out in the claims.

### BRIEF DESCRIPTION OF THE DRAWINGS

The above forgoing and other aspects will be described below in more detail with reference to the accompanying drawings of non-limiting embodiments, in which:
FIG. 1 is a diagram illustrating a semiconductor device according to an embodiment;
FIGS. 2A and 2B are top views showing an example of the first wafer and the second wafer of FIG. 1, respectively, according to an embodiment;
FIGS. 3A, 3B, and 3C are diagrams showing a misalignment detection circuit, according to an embodiment;
FIGS. 4A and 4B are diagrams for describing an operation of measuring a current flowing through the misalignment detection circuit, according to an embodiment;
FIG. 5 is a diagram showing a current flowing through a misalignment detection circuit in a normal-aligned state, according to an embodiment;
FIGS. 6A, 6B, 6C, and 6D are diagrams illustrating a misaligned status, according to an embodiment;
FIG. 7 is a diagram showing a current flowing through the misalignment detection circuit in the misaligned status of FIGS. 6A to 6C, according to an embodiment;
FIGS. 8A, 8B, 8C, and 8D are diagrams illustrating a misaligned status, according to an embodiment;
FIG. 9 is a diagram showing a current flowing through the misalignment detection circuit in the misaligned status of FIGS. 8A to 8C, according to an embodiment;
FIG. 10 is a diagram illustrating a plurality of misalignment detection circuits, according to an embodiment.
FIGS. 11A and 11B are diagrams for describing an operation of detecting a misalignment length and a misalignment direction, according to an embodiment;
FIG. 12 is a diagram illustrating a plurality of misalignment detection circuits, according to an embodiment;
FIGS. 13A, 13B, and 13C are diagrams for describing misalignment detection circuits in which a horizontal direction is in a misaligned status, according to an embodiment;
FIGS. 14A, 14B, and 14C are diagrams for describing misalignment detection circuits in which a vertical direction is in a misaligned status, according to an embodiment;
FIG. 15 is a diagram illustrating an embodiment of a semiconductor device, according to an embodiment;
FIGS. 16A, 16B, 16C, and 16D are diagrams illustrating a misalignment detection circuit, according to an embodiment;
FIG. 17 is a diagram illustrating the first wafer of FIG. 1, according to an embodiment.
FIG. 18 is a flowchart for describing an operation of measuring a current flowing through the misalignment detection circuit, according to an embodiment;
FIG. 19 is a flowchart for describing an operation of determining an alignment status of the misalignment detection circuit based on the measured current, according to an embodiment;
FIG. 20 is a diagram for describing a memory device according to an embodiment.

### DETAILED DESCRIPTION

In the following, various embodiments will be described clearly and in detail to the extent that a person skilled in the art can easily practice the present disclosure. In the drawings, like reference characters refer to like parts throughout the different views. The drawings are not necessarily to scale, emphasis instead being placed upon illustrating principles of present disclosure. It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section and do not denote any particular order unless an order is specifically described. Thus, a "first" element, component, region, layer or section described below could be termed a "second" element, component, region, layer or section, without departing from t scope of the present disclosure.

According to various embodiments, a misalignment detection circuit having improved performance and improved reliability is provided, and a yield of a memory device manufacturing process is improved.

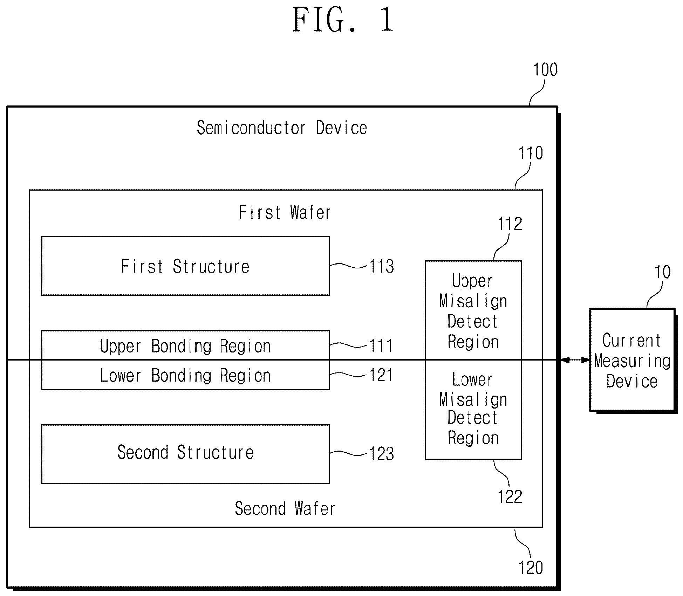

FIG. 1 is a diagram illustrating a semiconductor device according to an embodiment. Referring to FIG. 1, a semiconductor device 100 may include a first wafer 110 and a second wafer 120. In an embodiment, the semiconductor device 100 may include a memory device. For example, a memory device may include volatile memory, non-volatile memory, etc. Volatile memory may include DRAM, SRAM, etc., and non-volatile memory may include three-dimensional NAND flash memory, etc. The semiconductor device 100 of the present disclosure will be described as a memory device, but the scope of the present disclosure is not limited thereto. For example, the semiconductor device 100 may further include a CMOS image sensor other than a memory device, a central processing unit (CPU), a graphics processing unit (GPU), a neural processing unit (NPU), a sensor processing unit (TPU), a digital signal processing unit (DSP), an analog-to-digital converter (ADC), a digital-to-analog converter (DAC), a radio frequency (RF) chip, a field programmable gate array (FPGA), an application specific IC (ASIC), and the like.

A manufacturing process of the semiconductor device 100 may include a wafer-to-wafer (W2W) bonding process. The W2W bonding process may include a hybrid bonding process. The hybrid bonding may be a bonding that simultaneously implements electrical connection and physical coupling by simultaneously bonding a conductive material (e.g., copper) and an insulating material (e. g., a dielectric layer). In an embodiment, the W2W bonding process may be a step of manufacturing each of the first wafer 110 and the second wafer 120, and a step of bonding the first wafer 110 and second wafer 120. In some cases, one of the first wafer 110 and the second wafer 120 may be rotated by 180 degrees to be coupled. Referring to FIG. 1, the first wafer 110 may be rotated 180 degrees to be coupled with the second wafer 120. The manufacturing process of the semiconductor device 100 may include a C2C (Chip-to-Chip) bonding process, a C2W (Chip-to-Wafer) bonding process, etc., but the W2W bonding process is mainly described in the present disclosure.

In an embodiment, when performing the W2W bonding process, the first wafer 110 and the second wafer 120 may be misaligned. A misaligned status may refer to a status that occurs as a relative position between wafers deviates from a designed alignment position when performing a W2W bonding process. The misaligned status may be caused as in-plane movement (e.g., up-down or left-right direction) occurs between the first wafer 110 and the second wafer 120. In some embodiments, the misaligned status may be caused as rotation occurs between the first wafer 110 and the second wafer 120. However, the above-described misaligned status may be caused by various reasons, such as a precision limit of the alignment equipment, thermal deformation of the wafer, mechanical deformation of the wafer, etc.

The first wafer 110 may include an upper bonding region 111. The second wafer 120 may include a lower bonding region 121. The upper bonding region 111 may include a plurality of upper bonding pads. The lower bonding region 121 may include a plurality of lower bonding pads.

In an embodiment, when the first wafer 110 and the second wafer 120 are in a normal-aligned status upon performing the W2W process, the upper bonding region 111 and the lower bonding region 121 may be electrically connected. In an embodiment, when the first wafer 110 and the second wafer 120 are in the misaligned status upon performing the W2W process, a part of the upper bonding region 111 and a part of the lower bonding region 121 may not be electrically connected.

The first wafer 110 may include an upper misalignment detection region 112. The second wafer 120 may include a lower misalignment detection region 122. The upper misalignment detection region 112 may include at least one upper detection pad. The lower misalignment detection region 122 may include a plurality of lower detection pads.

In an embodiment, when the first wafer 110 and the second wafer 120 are in a normal-aligned status upon performing the W2W process, the at least one upper detection pad of the upper misalignment detection region 112 may not be electrically connected with the plurality of lower detection pads of the lower misalignment detection region 122. In an embodiment, when the first wafer 110 and the second wafer 120 are in a misaligned status upon performing the W2W process, the at least one upper detection pad of the upper misalignment detection region 112 may be electrically connected with some of the plurality of lower detection pads of the lower misalignment detection region 122.

In an embodiment, the current measuring device 10 may measure a current of the semiconductor device 100. For example, the current measuring device 100 may measure a current flowing between an upper detection pad of the upper misalignment detection region 112 and a lower detection pad of a lower misalignment detection region 122.

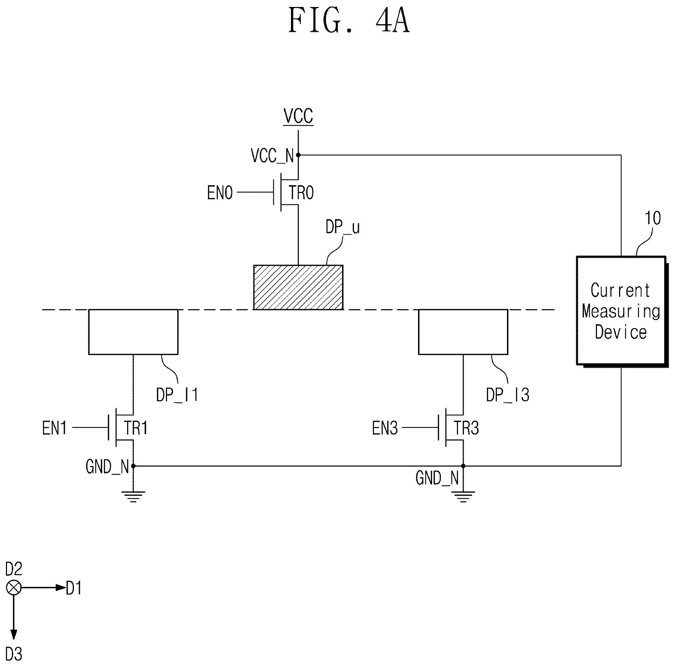

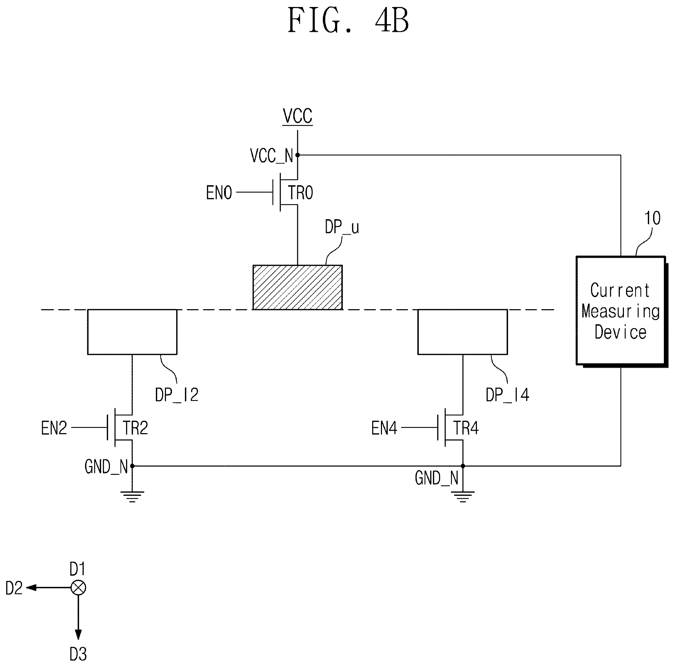

According to an embodiment of the present disclosure, a current flowing when an upper detection pad of the upper misalignment detection region 112 and a lower detection pad of a lower misalignment detection region 122 are in contact with each other may be measured through the current measuring device 10, and it may be determined whether the first wafer 110 and the second wafer 120 are in a normal-aligned status (e.g. correctly aligned) or a misaligned status based on the measured current. The operation of determining the aligned status of the wafers will be described below with reference to FIG. 4.

The first wafer 110 may include a first structure 113. The second wafer 120 may include a second structure 123. In an embodiment, when the semiconductor device 100 is a flash memory, the first structure 113 may include a memory cell array, the second structure 123 may include a peripheral circuit. In an embodiment, when the first wafer 110 and the second wafer 120 are in a misaligned status, performance degradation of the semiconductor device 100 may occur. For example, when the semiconductor device 100 is a flash memory, performance of an operation of writing data to the first structure 113 through the second structure 123 or reading data written to the first structure 133 may be degraded.

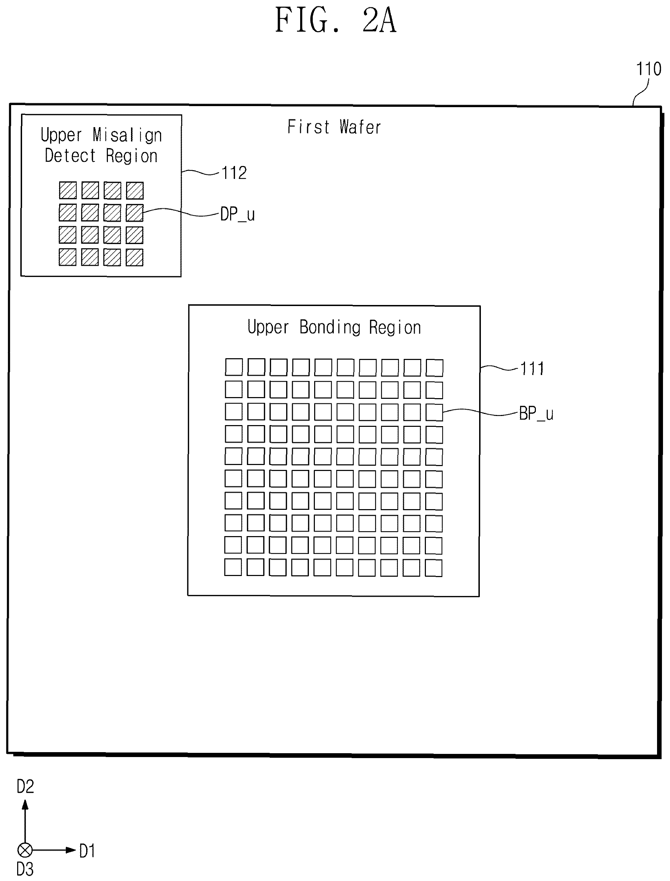

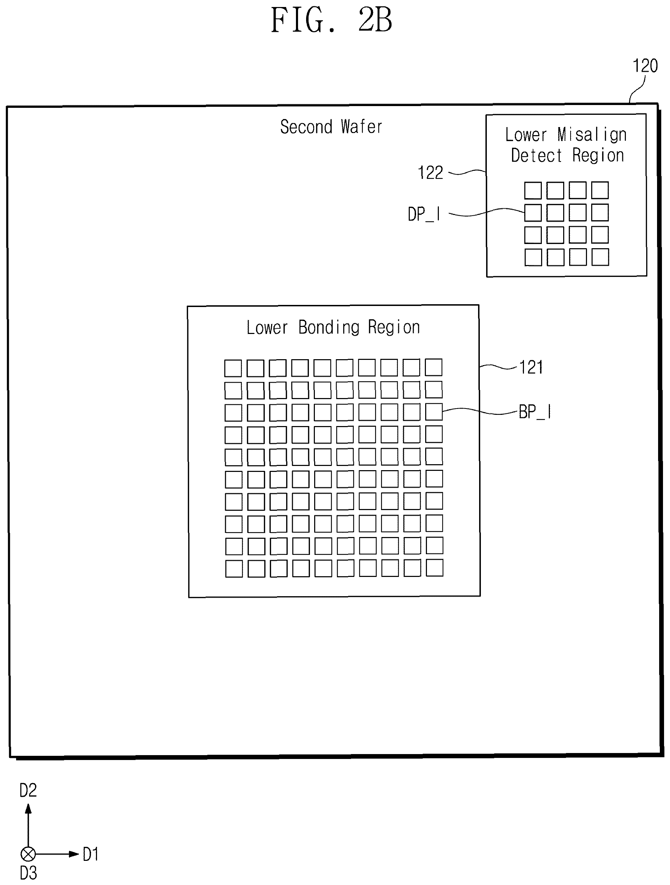

FIGS. 2A and 2B are top views showing an example of the first wafer and the second wafer of FIG. 1, respectively. Referring to FIGS. 2A and 2B, a first wafer 110 and a second wafer 120 viewed from a third direction D3 are shown. The third direction D3 may be a direction perpendicular to a plane formed by a first direction D1 and a second direction D2. Hereinafter, the first wafer 110 and the second wafer 120 are described with reference to FIGS. 2A and 2B together.

The first wafer 110 may include an upper bonding region 111 and an upper misalignment detection region 112. The second wafer 120 may include a lower bonding region 121 and a lower misalignment detection region 122.

The upper bonding region 111 may include a plurality of upper bonding pads BP_u. The plurality of upper bonding pads BP_u may be arranged along the first direction D1 and the second direction D2 on the upper bonding region 111.

The lower bonding region 121 may include a plurality of lower bonding pads BP_1. The plurality of lower bonding pads BP_1 may be arranged along the first direction D1 and the second direction D2 on the lower bonding detection region 121.

The upper misalignment detection region 112 may include at least one upper detection pad DP_u. The at least one upper detection pad DP_u may be arranged along the first direction D1 and the second direction D2 on the upper misalignment detection region 112.

The lower misalignment detection region 122 may include a plurality of lower detection pads DP_l. The plurality of lower detection pads DP_l may be arranged along the first direction D1 and the second direction D2 on the lower misalignment detection region 122.

In an embodiment, a size of the at least one upper detection pad DP_u and the plurality of lower detection pads DP_1 may be the same as a size of the upper bonding pad BP_u of the upper bonding region 111. In some embodiments, the size of the at least one upper detection pad DP_u and the size of the plurality of lower detection pads DP_1 may be the same as the size of the lower bonding pad BP_l of the lower bonding region 121.

In an embodiment, upon performing the W2W process, the first wafer 110 may be rotated 180 degrees to be coupled with the second wafer 120. In the present disclosure, it is described that the first wafer 110 is rotated 180 degrees in the first direction D1 to be coupled to the second wafer 120. When the first wafer 110 and the second wafer 120 are coupled, the upper bonding region 111 and the lower bonding region 121 may overlap. In some embodiments, when the first wafer 110 and the second wafer 120 are coupled, the upper misalignment detection region 112 and the lower misalignment detection region 122 may overlap each other.

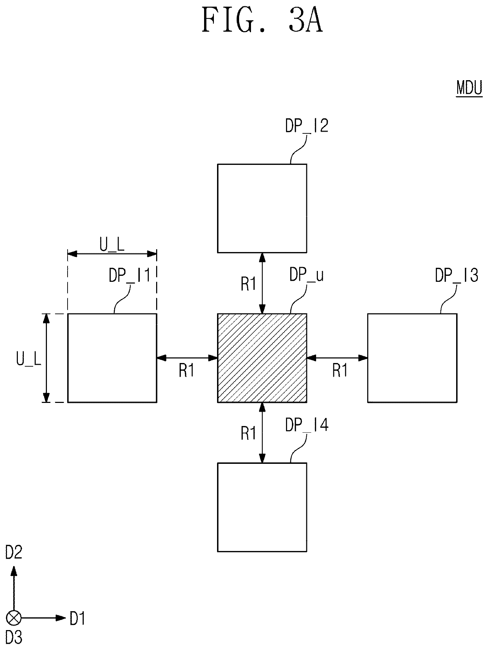

In an embodiment, when the first wafer 110 and the second wafer 120 are in a normal-alignment status, each of the plurality of upper bonding pads BP_u may be electrically connected to the corresponding one of the plurality of lower bonding pads BP_l. On the other hand, the at least one upper detection pad DP_u may not be electrically connected to the plurality of lower detection pads DP_l. (Additional details of the configuration will be described with respect to FIGS. 3A-3C below.)

In an embodiment, when the first wafer 110 and the second wafer 120 are in a misaligned status, some of the plurality of upper bonding pads BP_u may not be electrically connected to the corresponding ones of the plurality of lower bonding pads BP_l. On the other hand, the at least one upper detection pad DP_u may be electrically connected to some of the plurality of lower detection pads DP_1.

In an embodiment, when the upper detection pad DP_u and the lower detection pad DP_1 are not electrically connected, the magnitude of the current flowing between the upper detection pad DP_u and lower detection pads DP_l may be a first magnitude i1. For example, even if the upper detection pad DP_u and the lower detection pad DP_l are not electrically connected, a leakage current may still flow, and the current flowing between the upper detection pad DP_u and lower detection pads DP_1 may correspond to the leakage current. In an embodiment, when the upper detection pad DP_u and the lower detection pad DP_l are electrically connected, the magnitude of the current flowing between the upper detection pad DP_u and the lower detection pad DP_l may be a second magnitude i2. The first magnitude i1 may be less than or equal to the reference magnitude, and the second magnitude i2 may be greater than the reference magnitude.

According to an embodiment of the present disclosure, the alignment status of the wafers may be determined based on whether the magnitude of the current flowing between the upper detection pad DP_u and the lower detection pad DP_1 is greater than or less than the reference magnitude. For example, it may be determined that the wafers are in a normal-aligned status when the magnitude of the current flowing between the upper detection pad DP_u and the lower detection pad DP_1 is less than the reference magnitude i_REF. On the other hand, it may be determined that the wafers are in a misaligned status when the magnitude of the current flowing between the upper detection pad DP_u and the lower detection pad DP_l is greater than or equal to the reference magnitude i_REF.

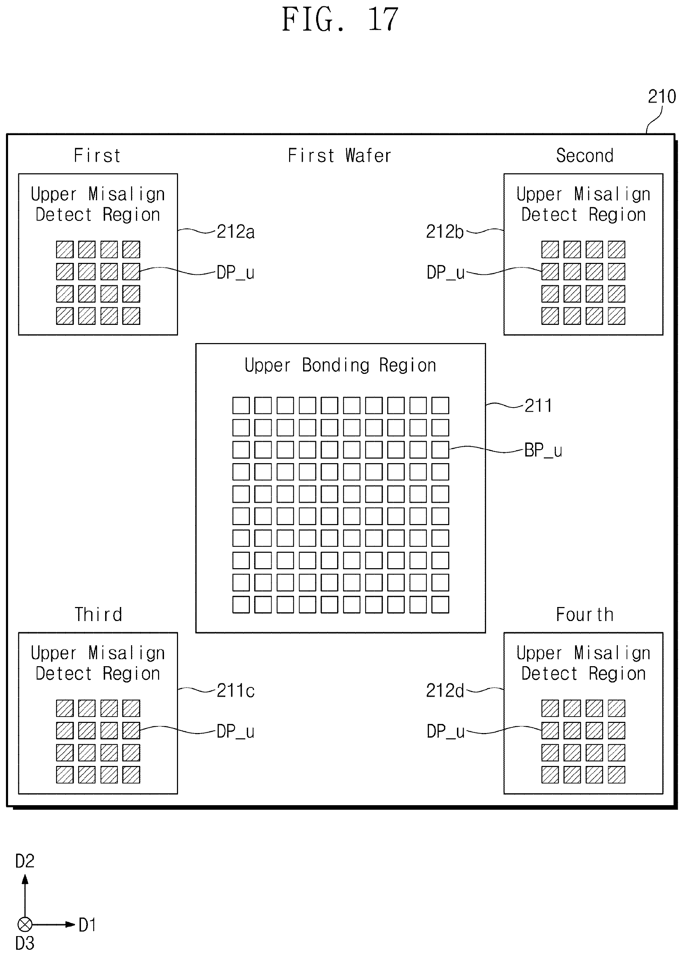

In an embodiment, referring to FIGS. 2A and 2B, the upper misalignment detection region 112 and the lower misalignment detection region 122 are shown as one, but the scope of the present disclosure is not limited thereto. For example, there may be a plurality of upper misalignment detection regions 112. For example, the upper misalignment detection region 112 may be additionally disposed at an opposite direction of the first direction and the second direction, at the first direction and the second direction, the first direction and a opposite direction of the second direction, or the first direction and the opposite direction of the second direction on the first wafer 110. In some embodiments, the upper misalignment detection region 112 may be additionally disposed in the opposite direction of the first direction side, the first direction side, the second direction side, or the opposite direction of the second direction side of the upper bonding region 111. In other words, the upper misalignment detection region 112 may be additionally disposed in one or more of the other four corners of the first wafer 110 in the plan view of FIG. 2A. The lower misalignment detection region 122 may be additionally disposed at a position corresponding to the upper misalignment detection region 112. In other words, the lower misalignment detection region 122 may be additionally disposed in one or more of the other four corners of the second wafer 120 in the plan view of FIG. 2B so as to correspond to the additional ones of the upper misalignment detection region 112. When the upper misalignment detection region 112 and the lower misalignment detection region 122 are plural, the misalignment status detection performance of the semiconductor device 100 can be improved. A case where there are the plurality of upper misalignment detection regions 112 and the plurality of lower misalignment detection regions 122 will be described in more detail with reference to FIG. 17.

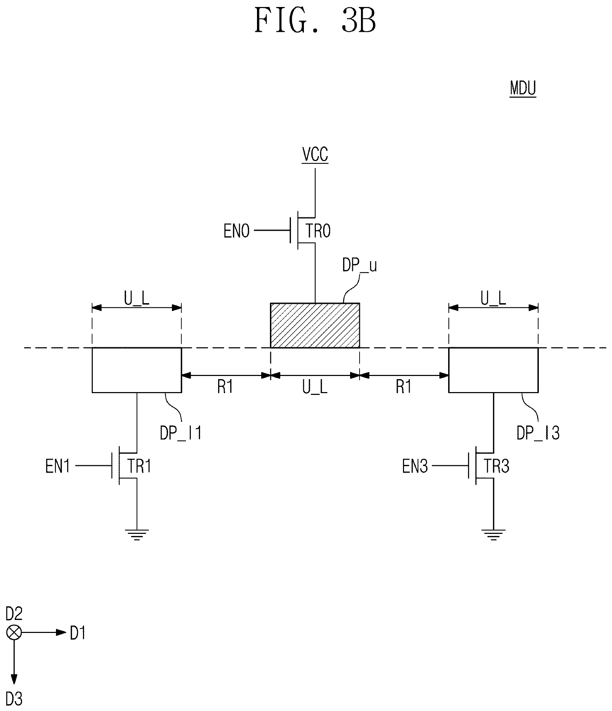

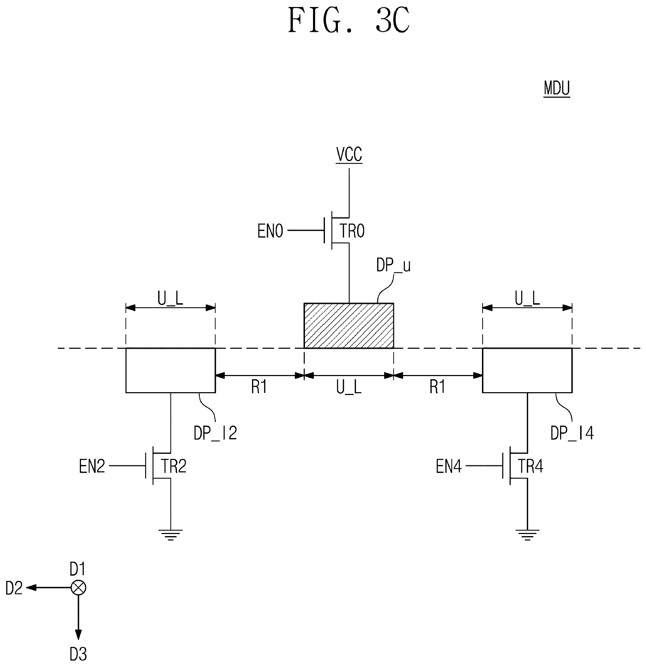

FIGS. 3A, 3B, and 3C are diagrams showing a misalignment detection circuit; according to an embodiment.

The misalignment detection circuit MDU may be a unit used by a test device to detect a misalignment status between wafers of the semiconductor device 100. For example, the misalignment detection circuit MDU may include one upper detection pad DP_u of the upper misalignment detection region 112 and four lower detection pads DP_l1 to DP_l4 of the lower misalignment detection region 122. The number of misalignment detection circuits MDU may be plural, and the test device may determine whether the wafers are in a normal-aligned status or a misaligned status based on the plurality of misalignment detection circuits MDU. For example, the test device may determine whether the wafers are in the normal-aligned status or the misaligned status based on a current flowing between the upper detection pad DP_u and the lower detection pad DP_1 of each of the plurality of misalignment detection circuits MDU.

FIG. 3A is a structure in which the misalignment detection circuit MDU is viewed from the third direction D3. FIG. 3B is a structure in that the misalignment detection circuit MDU is viewed from the second direction D2. FIG. 3C is a structure in the misalignment detection circuit MDU is viewed from the first direction D1.

The misalignment detection circuit MDU shown in FIGS. 3A, 3B, and 3C may be a structure of the misalignment detection circuit MDU when the aligned status between wafers is a normal-aligned status. Hereinafter, the structure of the misalignment detection circuit MDU in the normal-aligned status will be described in detail with reference to FIGS. 3A, 3B, and 3C.

The misalignment detection circuit MDU may include one upper detection pad DP_u and first to fourth lower detection pads DP_l1 to DP_l4. The upper detection pad DP_u may be included in the upper misalignment detection region 112, and the first to fourth lower detection pads DP_l1 to DP_l4 may be included in a lower misalignment detection region 122.

Each of the upper detection pad DP_u and the first to fourth lower detection pads DP_l1 to DP_l4 may have a same size. For example, referring to FIG. 3A, each of the upper detection pad DP_U and the first to fourth lower detection pads DP_l1 to DP_l4 may have a square shape in which the length of one side is a unit length U_L, but the shape of the detection pad is not limited thereto. For example, the shapes of the upper detection pad DP_u and the first to fourth lower detection pads DP_l1 to DP_l4 may not be square shapes for manufacturing process reasons. For example, the shape of the detection pad may have various shapes, such as a rectangular or round circular shape.

The first to fourth lower detection pads DP_l1 to DP_l4 may be spaced apart from the upper detection pad DP_u by a first separation distance R1. For example, the first lower detection pad DP_l1 may be spaced apart from the upper detection pad DP_u along the opposite direction of the first direction D1, the second lower detection pads DP_l2 may be spaced apart from the upper detection pads DP_u along the second direction D2, a third lower detection pad DP_l3 may be spaced apart from the upper detection pads DP_u along the first direction D1, and a fourth lower detection pad PD_14 may be spaced apart from the upper detection pad DP_u along the opposite direction of the second direction D2. However, the scope of the present disclosure is not limited thereto. The first to fourth lower detection pads DP_l1 to DP_l4 may be disposed to be spaced apart from each other in the vertex direction of the upper detection pad DP_u.

In an embodiment, each of the first to fourth lower detection pads DP_l1 to DP_l4 may be disposed to have a same distance from the upper detection pad DP_u. For example, each of the first to fourth lower-plate detection pads DP_l1 to DP_l4 may be spaced apart from the upper-plate detection pad DP_u by the first separation distance R1. The first separation distance R1 may be "a" times ("a" is a real number greater than 0) of the unit length U_L of each of the upper detection pad DP_u or the first to fourth lower detection pads DP_l1 to DP_l4. Although the first to fourth lower detection pads DP_l1 to DP_l4 of FIGS. 3A, 3B, and 3C are shown to be spaced apart from the upper detection pad DP_u by the same distance for convenience of description, the scope of the present disclosure is not limited thereto. For example, the upper detection pad DP_u in the normal-aligned status may be located at a position in an area where the upper detection pad DP_u is not connected with the first to fourth lower detection pads DP_l1 to DP_l4.

In an embodiment, the 0-th transistor TR0 may be connected to the upper detection pad DP_u. For example, one terminal of the 0-th transistor TR0 may be connected to the upper detection pad DP_u, and the other terminal of the 0-th transistor TR0 may receive a power supply voltage VCC. A 0-th enable signal EN0 may be applied to a gate terminal of the 0-th transistor TR0. For example, when the 0-th enable signal EN0 is applied to the gate terminal of the 0-th transistor TR0, the 0-th transistor TR0 may be turned on. When the 0-th activation signal EN0 is not applied to the gate terminal of the 0-th transistor TR0, the 0th transistor TR0 may be turned off.

The first transistor TR1 may be connected to the first lower detection pad DP_l1. For example, one terminal of the first transistor TR1 may be connected to the first lower detection pad DP_l1, and the other terminal of the first transistor TR1 may receive a ground voltage. The first enable signal EN1 may be applied to a gate terminal of the first transistor TR1. For example, when the first enable signal EN1 is applied to the gate terminal of the first transistor TR1, the first transistor TR1 may be turned on, and when the first enable signal EN1 is not applied to the gate terminal of the first transistor T1, the first transistor T1 may be turned off. Each of the second to fourth transistors TR2 to TR4 may be connected to the second to fourth lower detection pads DP_l2 to DP_l4 in the same manner or the similar manner as the first transistor TR1, and may be turned on or off based on the second to fourth enable signals EN2 to EN4 in the same manner or the similar manner as the first transistor TR1.

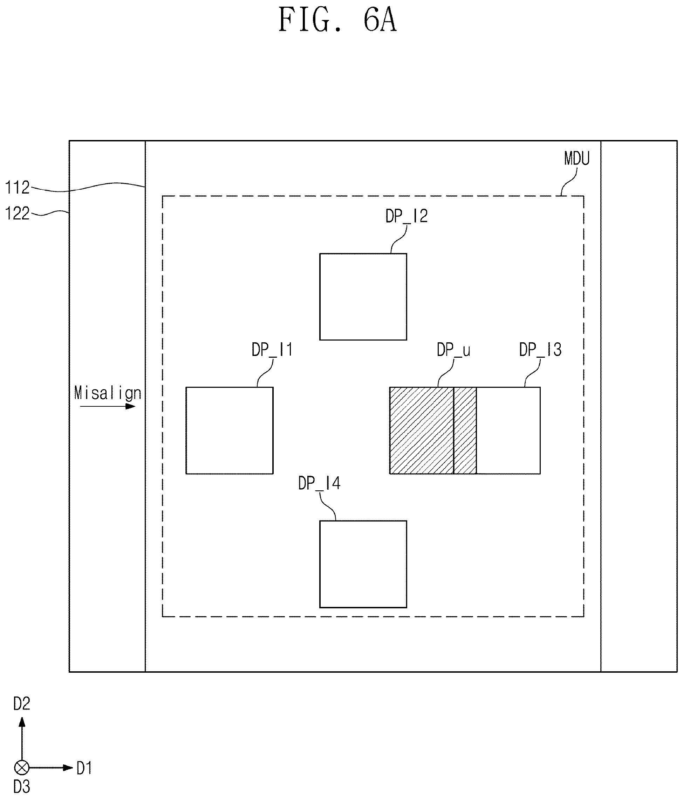

The misalignment detection circuit MDU shown in FIGS. 3A, 3B, and 3C may be a unit when wafers are in a normal-aligned status. Therefore, the upper detection pad DP_u may be a status which is not connected to the first to fourth lower detection pads DP_l1 to DP_l4. The structure of the misalignment detection circuit MDU when the wafers are in the misaligned status will be described later with reference to FIGS. 6A, 6B, 6C, 6D, 7, 8A, 8B, and 8C.

FIGS. 4A and 4B are diagrams for describing an operation of measuring a current flowing through the misalignment detection circuit, according to an embodiment.

FIG. 4A is a diagram for showing a connection form between the misalignment detection circuit MDU and the current measuring device 10 as viewed from the second direction D2, and FIG. 4B is a diagram for showing a connection form of the misalignment detection circuit MDU with the current measuring device 10, as viewed from the first direction D1. Hereinafter, an operation of measuring a current flowing through the misalignment detection circuit will be described with reference to FIGS. 4A and 4B together.

Referring to FIGS. 1, 2A, 2B, 3A, 3B, 3C, 4A, and 4B, the current measuring device 10 may be connected to a misalignment detection circuit MDU. For example, one terminal of the current measuring device 10 may be connected to a power supply voltage node VCC_N to which the power supply voltage VCC is applied, and the other terminal of the current measuring device 10 may be connected with a ground voltage node GND_N to which a ground voltage is applied.

The current measuring device 10 may sequentially measure a current between the upper detection pad DP_u and the first to fourth lower detection pads DP_l1 to DP_l4. First, the current measuring device 10 may measure a current between the upper detection pad DP_u and the first lower detection pad DP_l1. For example, when the 0-th enable signal EN0 is applied to the gate terminal of the 0-th transistor TR0 and the first enable signal EN1 is applied to the Gate terminal of the first transistor TR1, the current measuring device 10 may measure the current between the upper detection pad DP_u and the first lower detection pad DP_l1. Each of the second to fourth enable signals EN2 to EN4 may not be applied to the gate terminals of the second to the fourth transistors TR2 to TR4 while measuring the current between the upper detection pad DP_u and the first lower detection pad DP_l1.

After measuring the current between the upper detection pad DP_u and the first lower detection pad DP_l1, the current measuring device 10 may measure the current between the upper detection pad DP_u and the second lower detection pad DP_l2. For example, when the 0-th enable signal EN0 is applied to the 0-th transistor TR0 and the second enable signal EN2 is applied to the second transistor TR2, the current measuring device 10 may measure a current between the upper detection pad DP_u and the second lower detection pad DP_l2. Each of the first, third, and fourth enable signals EN1, EN3, EN4 may not be applied to the first, third and fourth transistors TR1, TR3, TR4 while measuring the current between the upper detection pad DP_u and the second lower plate detection pad DP_l2. In the above-described manner, the current measuring device 10 may sequentially measure the current between the upper detection pad DP_u and the third lower detection pad DP_l3 and the current between the lower detection pads DP_u and DP_l4.

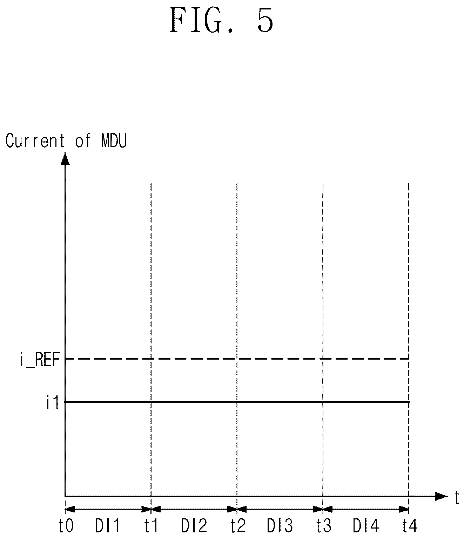

FIG. 5 is a diagram showing a current flowing through a misalignment detection circuit in a normal-aligned status, according to an embodiment.

Referring to FIGS. 1 to 5, a current flowing through the misalignment detection circuit MDU in a normal-aligned status, measured by the current measuring device 10 is shown. The misalignment detection circuit MDU in the normal-aligned status may be a status in which the upper detection pad DP_u is not in contact with the first to fourth lower detection pads DP_l1 to DP_l4 (e.g., the misalignment detection circuit MDU in FIGS. 3A to 3B).

The current measuring device 10 may sequentially measure a current between the upper detection pad DP_u and the first to fourth lower detection pads DP_l1 to DP_l4. First, the current measuring device 10 may measure a current between the upper detection pad DP_u and the first lower detection pad DP_l1 in the first measurement section DI1. For example, at the 0-th time point t0, the 0-th transistor TR0 and the first transistor TR1 may be turned on by applying the 0-th enable signal EN0 and the first enable signal EN1 to the 0-th transistor TR0 and the first transistor TR1, respectively, and the current measuring device 10 may measure a current between the upper detection pad DP_u and the first lower detection pad DP_l1. In the first measurement section DI1, the second to fourth enable signals EN2 to EN4 may not be applied to the second to fourth transistors TR2 to TR4.

In a second measurement section DI2, the current measuring device 10 may measure a current between the upper detection pad DP_u and the second lower detection pad DP_l2. For example, at the first time point t1, the 0-th enable signal EN0 and the second enable signal EN2 may be applied to the 0-th transistor TR0 and the second transistor TR2, respectively, and the current measuring device 10 may measure a current between the upper detection pad DP_u and the second lower detection pad DP_l2. In the above-described manner, the current measuring device 10 may measure the current between the upper detection pad DP_u and the third lower detection pad DP_13 in a third measurement section DI3, and may measure the current between the upper detection pad DP_u and fourth lower detection pads DP_l4 in a fourth measurement section DI4.

All of the magnitudes of the currents flowing through the misalignment detection circuit MDU measured in the first to fourth measurement sections DI1 to DI4 may be the first magnitude i1. The first magnitude i1 may be less than the reference magnitude i_REF. The test device may determine the alignment status of the misalignment detection circuit MDU based on the magnitude of the current flowing through the misalignment detection circuit MDU measured in the first to fourth measurement sections DIl to DI4. For example, the test device may determine that the misalignment detection circuit MDU is in a normal-aligned status based on that all of the magnitudes of the currents measured in the first to fourth measurement sections DI1 to DI4 are less than the reference magnitude i REF.

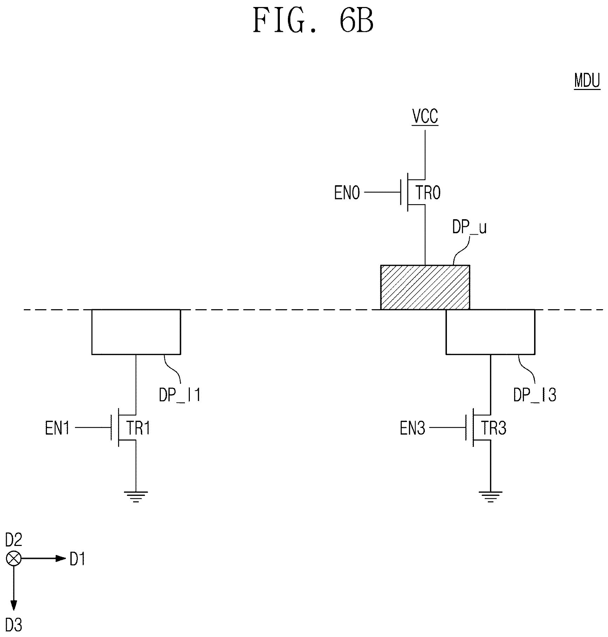

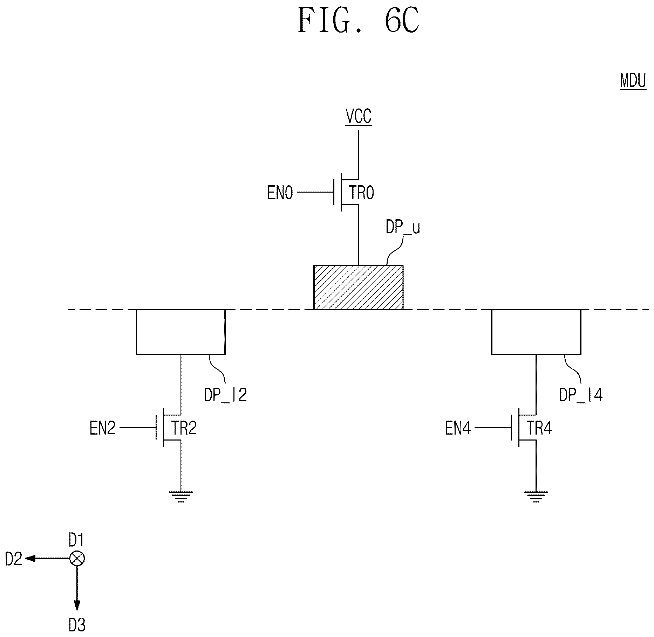

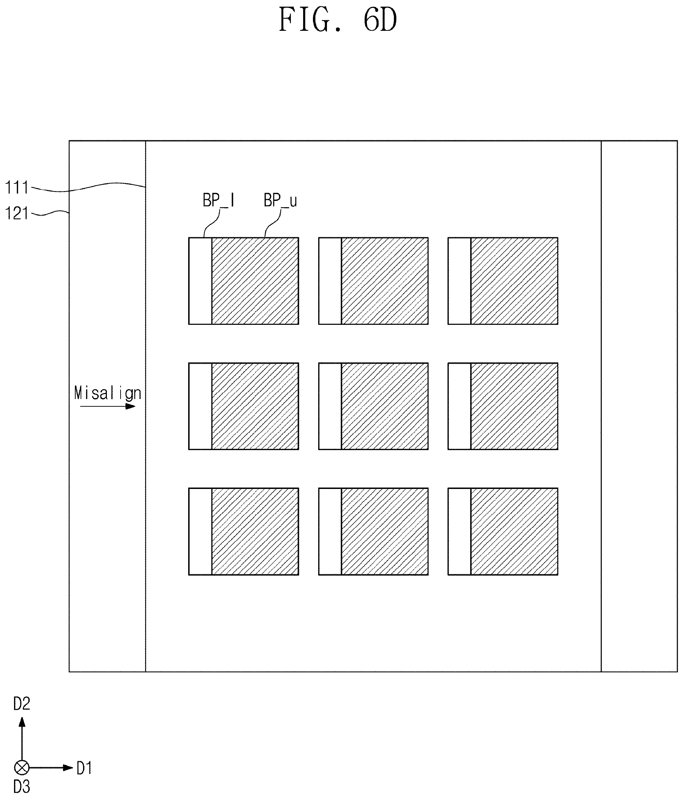

FIGS. 6A, 6B, 6C, and 6D are diagrams illustrating a misaligned state, according to an embodiment.

First, referring to FIG. 6A, an upper misalignment detection region 112 and a lower misalignment detection region 122 in a misaligned status as viewed in the third direction D3 are illustrated. The upper misalignment detection region 112 may include at least one upper detection pad DP_u. However, only one upper detection pad DP_u constituting one misalignment detection circuit MDU is illustrated in FIG. 6A. In an embodiment, the lower misalignment detection region 122 may include a plurality of lower detection pads DP_1. However, only the first to fourth lower detection pads DP_l1 to DP_l4 constituting one misalignment detection circuit MDU are illustrated in FIG. 6A.

Referring to FIG. 6A, the first wafer 110 (see FIG. 1) may have a misaligned status with respect to the second wafer 120 in the first direction. Therefore, the upper misalignment detection region 112 may have the misaligned status in the first direction with respect to the lower misalignment detection region 122. Accordingly, the upper detection pad DP_u included in one misalignment detection circuit MDU may also have in the misaligned status in the first direction.

Next, referring to FIG. 6B, the misalignment detection circuit MDU in the misaligned status as viewed from the second direction D2 is illustrated, and referring to FIG. 6C, the misalignment detection circuit MDU in the misaligned status as viewed in the first direction D1 is illustrated.

Referring to FIG. 6B, the upper detection pad DP_u may not be connected with the first lower detection pad DP_l1 and may contact to (e.g. may be connected with) a third lower detection pad DP_l3. Referring to FIG. 6C, the upper detection pad DP_u may not be connected to second and fourth lower detection pads DP_l2 and DP_l4.

When the misalignment detection circuit MDU is in the misaligned state, the current flowing through the misaligning detection circuit MDU may increase. For example, referring to FIGS. 6A, 6B, and 6C, the upper detection pad DP_u and the third lower detection pad DP_l3 are connected to each other, and thus the current flowing between the upper detection pad DP_u and third lower detection pad DP_l3 may increase.

Referring to FIG. 6D, an upper bonding region 111 and a lower bonding region 121 in a misaligned-status are shown. The upper bonding region 111 may include a plurality of upper bonding pads BP_u, and the lower bonding region 121 may include the plurality of lower bonding pads BP_l.

Referring to FIG. 6D, the first wafer 110 (see FIG. 1) may have a misaligned status with respect to the second wafer 120 in the first direction. Therefore, the upper bonding region 111 may have the misaligned status in the first direction with respect to the lower bonding region 121. Accordingly, the plurality of upper bonding pads BP_u may also be misaligned in the first direction.

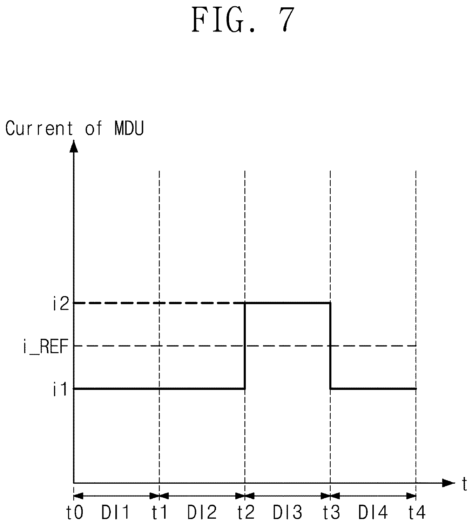

FIG. 7 is a diagram showing a current flowing through the misalignment detection circuit in the misaligned status of FIGS. 6A, 6B, and 6C, according to an embodiment.

Referring to FIG. 7, a current flowing through the misalignment detection circuit MDU in the misaligned status is shown and the current may be measured by the current measuring device 10. For example, the current measuring device 10 may sequentially measure a current between the upper detection pad DP_u and the first to fourth lower detection pads DP_l1 to DP_l4. Since description of the specific operation for sequentially measuring the current is described in reference with the above drawings, further details thereof are omitted for conciseness.

The upper detection pad DP_u of the misalignment detection circuit MDU may be connected to the third lower detection pad DP_l3. Therefore, the magnitude of the current measured in the third measurement section DI3 may be greater than the magnitude of the electric current measured in the first, second, or fourth measurement sections DI1, DI2, or DI4. For example, the magnitude of the current flowing between the upper detection pad DP_u and the third lower detection pad DP_l3 may be the second magnitude i2, and the magnitude of the electric current flowing between the upper detection pad DP_u and the first, second, or fourth lower detection pads DP_l1, DP_I2, and DP_l4 may be the first magnitude i1. The second magnitude i2 may be greater than the reference magnitude i_REF, and the first magnitude i1 may be less than the reference magnitude i_REF.

The test device according to an embodiment of the present disclosure may determine that the misalignment detection circuit MDU is in a misalignment status based on the fact that a part of magnitudes of currents measured in the first to fourth measurement sections DI1 to DI4 is equal to or greater than the reference magnitude I_REF. For example, the test device may determine that it is a misaligned status in a direction in which the third lower pad DP_l3 is disposed, based on the fact that the current measured during the third measurement section DI3 has a magnitude equal to or greater than the reference magnitude i_REF.

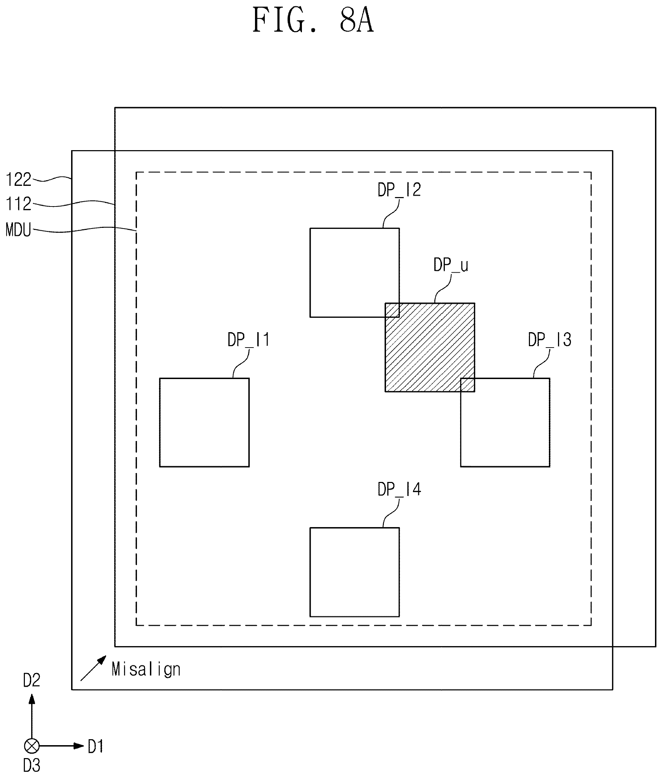

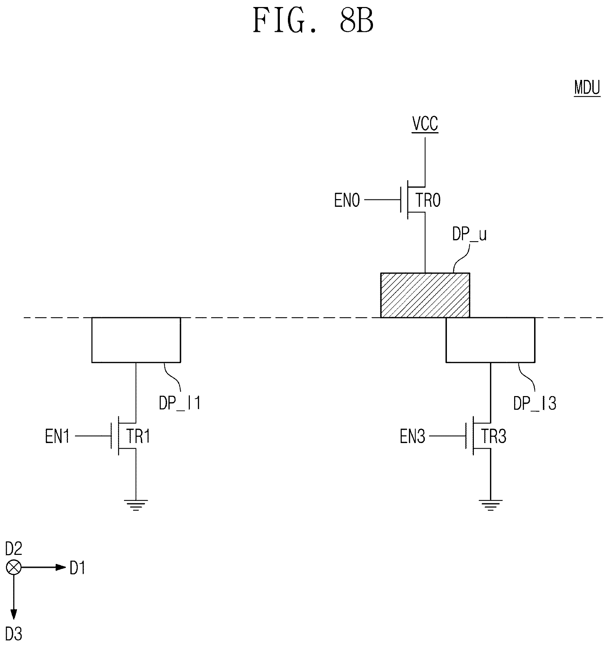

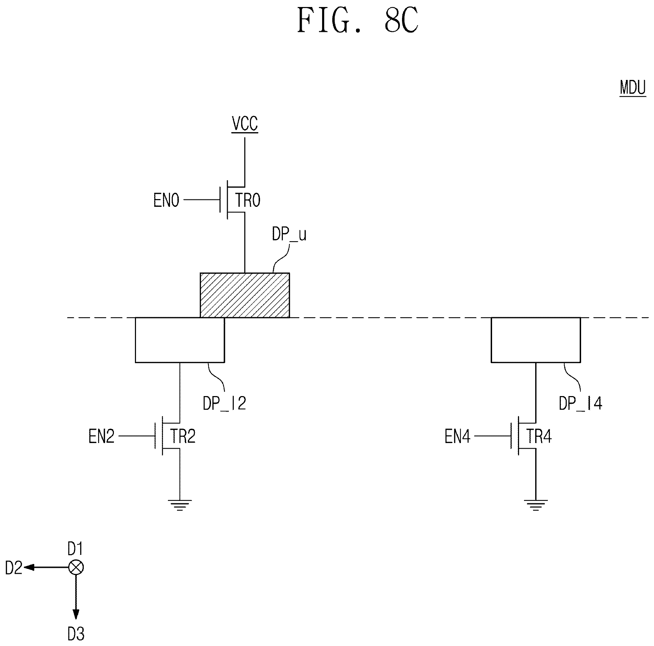

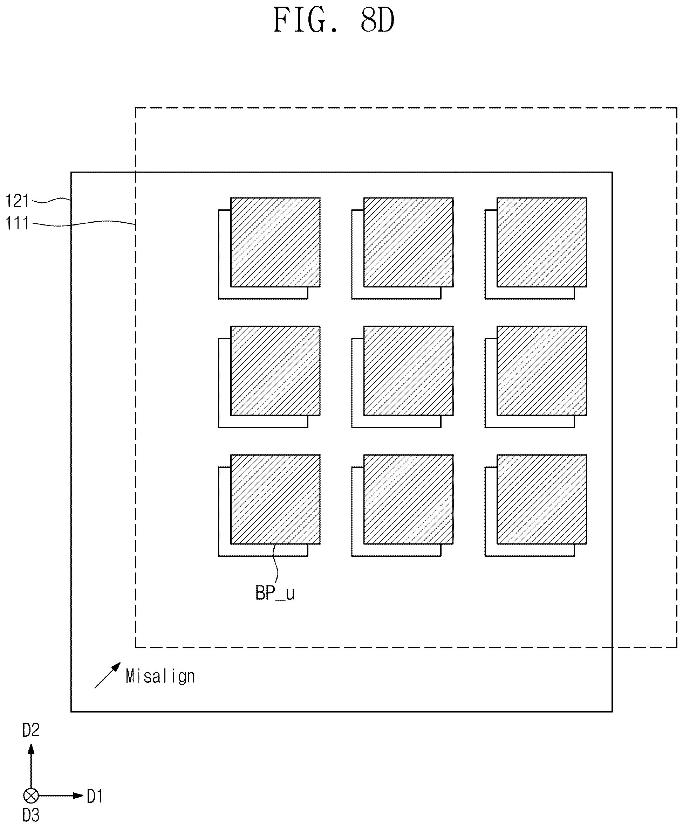

FIGS. 8A, 8B, 8C, and 8D are diagrams illustrating a misaligned status, according to an embodiment.

First, referring to FIG. 8A, an upper misalignment detection region 112 and a lower misalignment detection region 122 in a misalignment status as viewed in the third direction D3 are illustrated. The upper misalignment detection region 112 may include at least one upper detection pad DP_u. However, only one upper detection pad DP_u included in one misalignment detection circuit MDU is illustrated in FIG. 8A. In an embodiment, the lower misalignment detection region 122 may include a plurality of lower detection pads DP_1. However, only the first to fourth lower detection pads DP_l1 to DP_l4 included in one misalignment detection circuit MDU are illustrated in FIG. 8A.

Referring to FIG. 8A, the first wafer 110 may have a misaligned status with respect to the second wafer 120 in a direction between the first direction D1 and the second direction D2. Therefore, the upper misalignment detection region 112 may have a misaligned status in the first direction and the second direction with respect to the lower misalignment detection region 122. Accordingly, the upper detection pad DP_u included in one misalignment detection circuit MDU may also have the misaligned status in the direction between the first direction D1 and the second direction D2.

Next, referring to FIG. 8B, the misalignment detection circuit MDU in the misaligned status as viewed from the second direction D2 is illustrated, and referring to FIG. 8C, the misalignment detection circuit MDA in the misaligned status as viewed in the first direction D1 is illustrated.

Referring to FIG. 8B, the upper detection pad DP_u may not be connected to the first lower detection pad DPl1, but may be connected to a third lower detection pad DP_l3. Referring to FIG. 8C, the upper detection pad DP_u may be connected to the second lower detection pad DP_l2 and may not be connected to the fourth lower detection pad DP_l4.

When the misalignment detection circuit MDU is in the misaligned status, the current flowing between the upper detection pad DP_u and the lower detection pad DP_l may increase. For example, referring to FIGS. 8A, 8B, and 8C, the upper detection pad DP_u may be connected to the second and third lower detection pads DP_l2 and DP_l3, thereby the current between the upper detection pad DP_u and the second and third lower detection pads DP_l2 and DP_l3 may increase.

Referring to FIG. 8D, an upper bonding region 111 and a lower bonding region 121 in a misaligned status are shown. The upper bonding region 111 may include a plurality of upper bonding pads BP_u, and the lower bonding region 121 may include the plurality of lower bonding pads BP_l.

Referring to FIG. 8D, the first wafer 110 may be in a misaligned status with respect to the second wafer 120 in a direction between the first direction D1 and the second direction D2. Therefore, the upper bonding region 111 may be in a misaligned status in the direction between the first direction D1 and the second direction D2 with respect to the lower bonding region 121. Accordingly, the plurality of upper bonding pads BP_u may also be misaligned in the direction between the first direction D1 and the second direction D2.

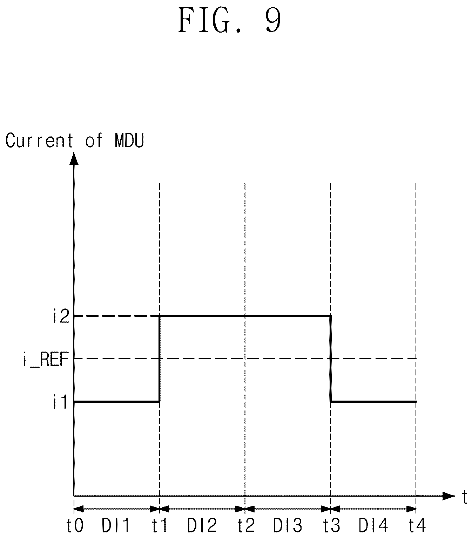

FIG. 9 is a diagram showing a current flowing through the misalignment detection circuit MDU in the misaligned state, according to an embodiment.

Referring to FIG. 9, the current of the misalignment detection circuit MDU measured by the current measuring device 10 is shown. For example, the current measuring device 10 may sequentially measure a current flowing between the upper detection pad DP_u and each of the first to fourth lower detection pads DP_l1 to DP_l4. Description of the specific operation of sequentially measuring the current is omitted for conciseness.

The upper detection pad DP_u of the misalignment detection circuit MDU may be connect to the second and third lower detection pads DP_l2 and DP_l3. Accordingly, the magnitude of the current measured in the second and third measurement sections DI2 and DI3 may be greater than the magnitude of the current measured in the first and fourth measurement sections DI1 and DI4. For example, the magnitude of the current measured in the second and third measurement sections DI2 and DI3 may be the second magnitude i2, and the magnitude of the current measured in the first and fourth measurement sections DI1 and DI4 may be the first magnitude i1. The second magnitude i2 may be equal to or greater than the reference magnitude i_REF, and the first magnitude i1 may be less than the reference magnitude i_REF.

The test device according to an embodiment of the present disclosure may determine as the misalignment detection circuit MDU is in a misalignment status when a magnitude of at least part of the currents measured in the first to fourth measurement sections DI1 to DI4 is equal to or greater than the reference magnitude i_REF. For example, the test device may determine that the misalignment detection circuit MDU is in the misaligned status based on the magnitude of the current measured in the second and third measurement sections DI2 and DI3 being equal to or greater than the reference magnitude i_REF. The test device may determine that the second and third lower pads DP_l2 and DP_13 of the misalignment detection circuit MDU are in a misaligned status in a direction in which they are disposed.

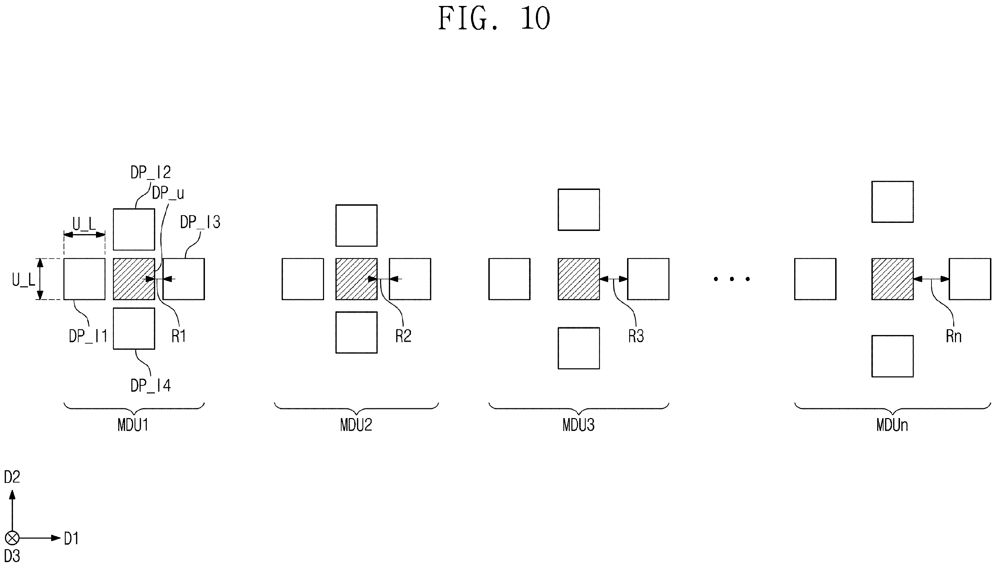

FIG. 10 is a diagram illustrating a plurality of misalignment detection circuits, according to an embodiment.

The test device according to an embodiment of the present disclosure may determine a misalignment length through a plurality of misalignment detection circuits MDU1 to MDUn. The misalignment length may denote a length that deviates from the area in which the wafer is designed to be aligned. The test device may determine the misalignment detection circuits in the misaligned status among the plurality of misalignment detection circuits MDU1 to MDUn, and determine the misalignment length (e.g. the amount of misalignment) based on the misalignment detection circuit having a largest separation distance of a lower detection pad among the determined misalignment detection circuit units. Each of the plurality of misalignment detection circuits MDU1 to MDUn may have a form of the misalignment detection circuit shown in FIGS. 3A, 3B, and 3C. The misalignment detection circuits MDU1 to MDUn illustrated in FIG. 10 may be in a normal-aligned status.

Referring to FIG. 1, 2, 3A, 3B, and 10, a first misalignment circuit MDU1, a second misalignment circuit MDU2, a third misalignment circuit MDU3, ..., to an n-th misalignment detection circuit MDUn are illustrated. The upper detection pads DP_u of the first to n-th misalignment detection circuits MDU1 to MDUn may be included in the upper misalignment detection region 112 and the lower detection pads DP_1 of the first to n-th misalignment detection circuits MUD1 to MDUn may be included in the lower misalignment detection region 122. Each of the first to n-th misalignment detection circuits MDU1 to MDUn may include one upper detection pad DP_u and first to fourth lower detection pads DP_l1 to DP_l4. Each of the upper detection pad DP_u and the first to fourth lower detection pads DP_l1 to DP_l4 may have a square shape in which the length of one side is a unit length U_L, but the shape of the detection pad is not limited thereto. For example, the shapes of the upper detection pad DP_u and the first to fourth lower detection pads DP_l1 to DP_l4 may not be square shapes for manufacturing process reasons. For example, the shape of the detection pad may have various shapes, such as a rectangular or round circular shape.

The first to n-th misalignment detection circuits MDU1 to MDUn may have a first separation distance R1, a second separation distance R2, a third separation distance R3, ..., to a n-th separation distances R1 to Rn, respectively. For example, the upper detection pad DP_u and the first to fourth lower detection pads DP_l1 to DP_l4 in the first misalignment detection circuit MDU1 may have a first separation distance R1, and the upper detection pad DP_u and the first to the fourth lower detection pads DP_l1-DP_l4 in the second misalignment detection circuit MDU2 may have the second separation distance R2. As described above, each of the upper detection pad DP_u and the first to fourth lower detection pads DP_l1 to DP_l4 in the third to n-th misalignment detection circuits MDU3 to MDUn may have third to n-th separation distances R1 to Rn, respectively.

The first to n-th separation distances R1 to Rn may be A times the unit length U_L of each of the upper detection pad DP_u or the first to fourth lower detection pads DP_l1 to DP_l4 (where A is a real number greater than 0).

In an embodiment, the first to n-th separation distances R1 to Rn may be different from each other. For example, the separated distances R1 to Rn of the plurality of misalignment detection circuits MDU1 to MDUn illustrated in FIG. 10 may increase. For example, the first separation distance R1 of the first misalignment detection circuit MDU1 may be the smallest distance. The second separation distance R2 of the second misalignment detection circuit MDU2 may be greater than the first separation distance R1. The third separation distance R3 of the third misalignment detection circuit MDU3 may be greater than the second separation distance R2. As described above, as the first to n-th separation distances R1 to Rn of the misalignment detection circuits MDU1 to MDUn gradually increase, the n-th separation distance Rn of the n-th misalignment detection circuit MDUn may be the largest distance. A ratio at which the first to n-th separation distances R1 to Rn increase may be constant, but the scope of the present disclosure is not limited thereto.

In an embodiment, for ease of description, the separation distances R1 to Rn between the detection pads of the plurality of misalignment detection circuits MDU1 to MDUn are shown to gradually increase. However, the scope of the present disclosure is not limited thereto. For example, in an embodiment, the separation distances R1 to Rn between the detection pads of the plurality of misalignment detection circuits MDU1 to MDUn may gradually decrease. In some embodiments, a plurality of detection circuits MDU1 to MDUn having first to n-th separation distances R1 to Rn may be randomly arranged.

In an embodiment, referring to FIG. 10, the plurality of misalignment detection circuits MDU1 to MDUn are shown to be arranged along the first direction D1 (that is, a row direction). However, the scope of the present disclosure is not limited thereto. For example, in an embodiment, the plurality of misalignment detection circuits MDU1 to MDUn may be arranged along the second direction D2 (that is, a vertical direction). In some embodiments, referring to FIG. 10, a plurality of misalignment detection circuits MDU1 to MDUn are shown to be arranged along one row, but the scope of the present disclosure is not limited thereto. For example, a plurality of misalignment detection circuits MDU1 to MDUn may be arranged along two or more rows. That is, an arrangement form of the misalignment detection circuits MDU1 to MDU1 may vary.

In an embodiment, the test device according to an embodiment of the present disclosure may detect a misalignment direction based on misalignment detection circuits in a misaligned status. For example, the misalignment direction may be detected based on a current flowing between the upper bonding pad BP_u and the first to fourth lower bonding pads BP_l1 to BP_l4 of the misalignment detection circuits MDU1 to MDUn in which misalignment has occurred.

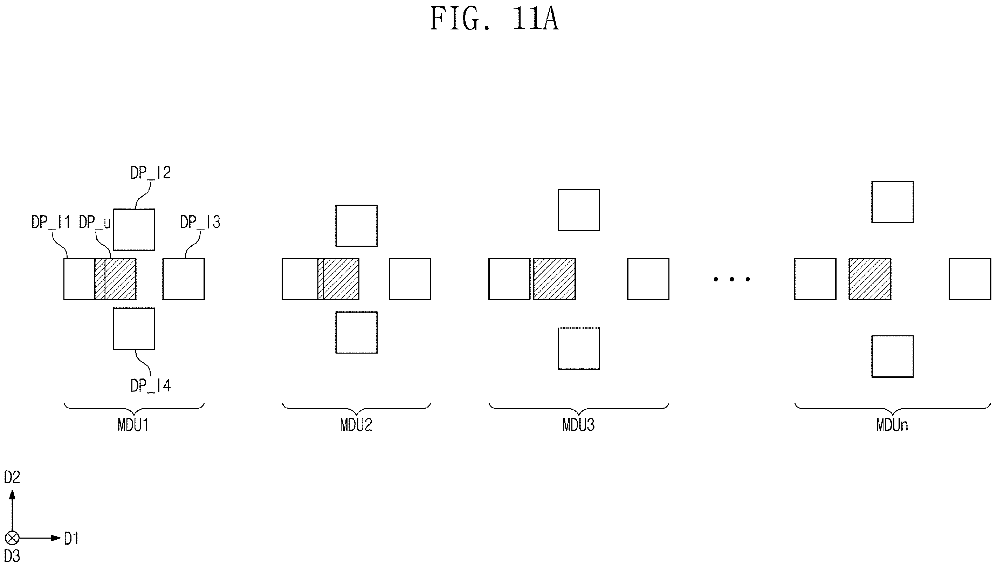

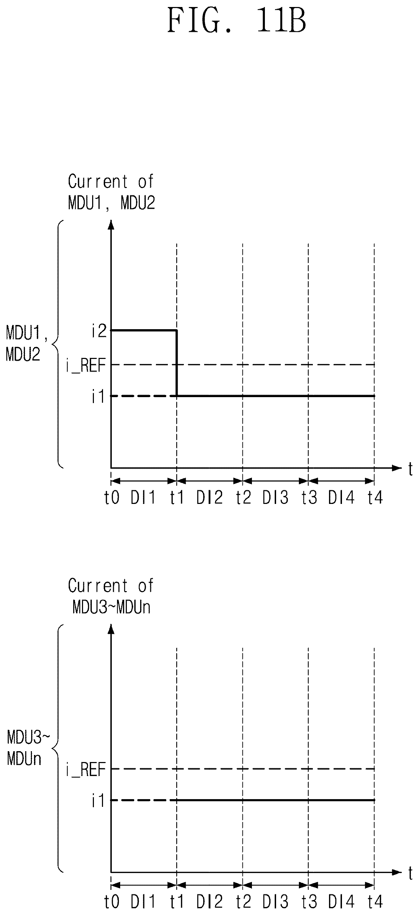

In an embodiment, the test device according to an embodiment of the present disclosure may detect a misalignment length based on misalignment detection circuits in which misalignment has occurred. For example, the misalignment length may be detected based on a misalignment detection circuit having the largest separated distance among misalignment detection circuits in the misaligned status. The operation of the test device detecting the misalignment length and the misalignment direction is described in more detail with reference to FIGS. 11A and 11B.

FIGS. 11A and 11B are diagrams for describing an operation of detecting a misalignment length and a misaligning direction, according to an embodiment.

Referring to FIG. 11A, the first wafer 110 may be in a misaligned status with respect to the second wafer 120. For example, the first wafer 110 may be in a misaligned status with respect to the second wafer 120 in an opposite direction (e.g., -D1) of the first direction D1. In this case, the alignment status of the first to fourth misalignment detection circuits MDU1 to MDU4 may be determined according to the misalignment length. For example, according to the misalignment length, the first and second misalignment detection circuits MDU1 and MDU2 among the plurality of misalignment detection circuits MDU1 to MDU1 may be in a misaligned status, and the third to n-th misalignment detection circuit units MDU3 to MDU1 are in a normal-aligned status. For example, in the first and second misalignment detection circuits MDU1 and MDU2, the upper detection pad DP_u may be connected to the first lower detection pad DP_l1 and may not be connected to the second to fourth lower detection pads DP_l2 to DP_l4.

The test device 100 according to an embodiment of the present disclosure may detect a misalignment direction based on misalignment detection circuits in a misaligned status. For example, in the first and second misalignment detection circuits MDU1 and MDU2 in which misalignment has occurred, since the upper detection pad DP_u is connected to the first lower detection pad DP_l1, it may be detected that misalignment occurs in a direction in which the first lower detection pad DP_l1 is disposed.

The test device according to an embodiment of the present disclosure may detect a misalignment length based on misalignment detection circuits in a misaligned status. For example, since the first and the second misalignment detection circuits MDU1 and MDU2 among the plurality of misalignment detection circuits MDU1 to MDUn is in a misalignment status and the third to n-th misalignment determining units MDU3 to MDUn is in a normal-aligned status, the test device may detect that the second misalignment detection circuit MDU2 is misaligned by the separation distance R2.

Referring to FIG. 11B, currents of the first to n-th misalignment detection circuits MDU1 to MDUn are illustrated.

The magnitude of the current flowing through the detection pad that is connected to the upper detection pad DP_u among the lower detection pads DP_l1 to DP_l4 of the first and second misalignment detection circuits MDU1 and MDU2 may be greater than or equal to the reference magnitude i_REF. For example, the magnitude of the current flowing between the upper detection pad DP_u and the first lower detection pad DP_l1 of the first and second misalignment detection circuits MDU1 and MDU2 may be the second magnitude i2, and the second magnitude i2 may be greater than or equal to the reference magnitude i_REF.

The magnitude of the current flowing through the detection pad that is not connected to the upper detection pad DP_u among the lower detection pads DP_l1 to DP_l4 of the first and second misalignment detection circuits MDU1 and MDU2 may be less than the reference magnitude i_REF. For example, the magnitude of the current flowing between the upper detection pad DP_u and the second to fourth lower detection pads DP_l2 to DP_l4 of the first and second misalignment detection circuits MDU1 and MDU2 may be the first magnitude i1. The first magnitude i1 may be less than the reference magnitude i_REF.

Since the upper detection pads DP_l1 to DP_l4 of the third to n-th misalignment detection circuits MDU3 to MDUn do not contact the first to fourth lower detection pads DP_11 to BP_14, the magnitude of the current measured in the first to fourth measurement sections DI1 to DI4 may be the first magnitude i1 less than the reference magnitude i_REF.

The test device according to an embodiment of the present disclosure may detect a misalignment direction and a misalignment length based on magnitudes of currents flowing through the first to n-th misalignment detection circuits MDU1 to MDUn. For example, the test device may detect that the misalignment direction is a direction in which the first lower detection pad DP_l1 is disposed based on the magnitude of the current flowing through the first lower detection pad DP_l1 of the first and second misalignment detection circuits MDU1 and MDU2 being equal to or greater than the reference magnitude i_REF. In an embodiment, the test device may detect that the misalignment length is the second separation distance R2 of the second misalignment detection circuit MDU2 having a larger separation distance among the first and second misalignment detection circuits MDU1 to MDU2 in which the misalignment has occurred.

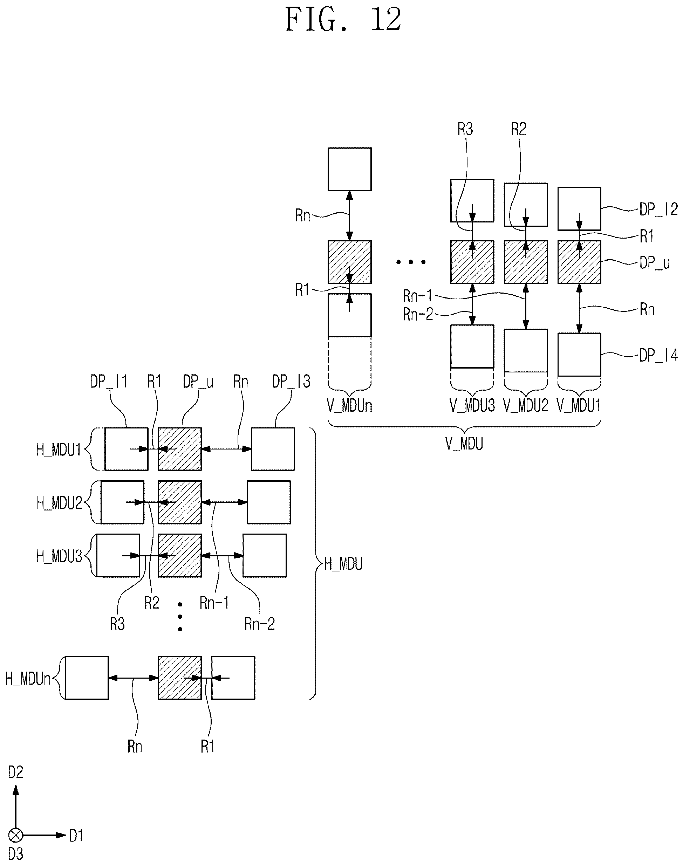

FIG. 12 is a diagram illustrating a plurality of misalignment detection circuits, according to an embodiment.

Referring to FIG. 12, horizontal misalignment detection circuits H_MDU and vertical misalignment detection circuits V_MDU are shown. In an embodiment, the plurality of misalignment detection circuits may include horizontal and vertical misalignment detection circuits H_MDU and V_MDU. For example, the horizontal misalignment detection circuits H_MDU may detect a misalignment status in the first direction D1. The vertical misalignment detection circuits V_MDU may detect a misalignment status in the second direction D2. The horizontal misalignment units H_MDU and the vertical misalignment unit V_MDU may be included in the upper misalignment detection region 112 and the lower misalignment detection region 122.

The horizontal misalignment detection circuits H_MDU may include first to n-th horizontal misalignment detection circuits H_MTU1 to H_MDUn. The vertical misalignment detection circuits V_MDU may include first to n-th vertical misalignment detection circuits V_MDU1 to V_MDUn.

Each of the first to n-th horizontal misalignment detection circuits H_MDU1 to H_MDUn may include one upper detection pad DP_u and two lower detection pads DP_l1 and DP_13. For example, the first lower detection pad DP_l1 may be spaced apart from the upper detection pad DP_u along the opposite direction of the first direction D1, and the third lower detection pad DP_l3 may be spaced apart from the upper detection pad DP_u along the first direction D1.

Each of the first to n-th vertical misalignment detection circuits V_MDU1 to V_MDUn may include one upper detection pad DP_u and two lower detection pads DP_l2 and DP_l4. The second lower detection pad DP_l2 may be spaced apart from the upper detection pad DP_u along the second direction D2, and the fourth lower detection pad DP_l4 may be spaced apart from the upper detection pad DP_u along the opposite direction of the second direction D2.

The separation distances R1 to Rn between the upper detection pad DP_u and the first lower detection pad DP_l1 of the first to n-th horizontal misalignment detection circuits H_MDU1 to H_MDUn may be different from each other. Referring to FIG. 12, the separation distances R1 to Rn between the upper detection pad DP_u and the first lower detection pad DP_l1 of the first to n-th horizontal misalignment detection circuits H_MDU1 to H_MDUn may increase along the opposite direction of the second direction D2. For example, the first separation distance R1 between the upper detection pad DP_u and the first lower detection pad DP_l1 in the first horizontal misalignment detection circuit H_MDU1 may be the smallest distance, and the n-th separation distance Rn between the upper detection pad DP_u and the first lower detection pad DP_l1 in the n-th horizontal misalignment detection circuit H_MDUn may be the largest distance.

The separation distances Rn to Rl between the upper detection pad DP_u and the third lower detection pad DP_l3 of the first to n-th horizontal misalignment detection circuits H_MDU1 to H_MDUn may be different from each other. Referring to FIG. 12, the separation distances R1 to Rn between the upper detection pad DP_u and the third lower detection pad DP_l3 may decrease along the opposite direction of the second direction D2. For example, the n-th separation distance Rn between the upper detection pad DP_u and the third lower detection pad DP_l3 in the first horizontal misalignment detection circuit H_MDU1 may be the largest distance, and the first separation distance R1 between the upper detection pad DP_u and the third lower detection pad DP_l3 in the n-th horizontal misalignment detection circuit H_MDUn may be the smallest distance.

In an embodiment, a ratio of an increase in the separation distances Rl to Rn between the upper detection pad DP_u and the first lower detection pad DP_l1 may be the same as a ratio of a decrease in the separation distance Rn to R1 between the upper detection pad DP_u and the third lower detection pad DP_l3. For example, the first separation distance R1 between the upper detection pad DP_u and the first lower detection pad DP_l1 of the first horizontal misalignment detection circuit H_MDU1 may be the same as the first separation distances R1 between the upper detection pad DP_u and the third lower detection pads DP_l3 of the n-th horizontal misalignment detection circuit H_ MDUn. In some embodiments, the second separation distance R2 between the upper detection pad DP_u and the first lower detection pad DP_l1 of the second horizontal misalignment detection circuit H_MDU2 may be the same as the second separation distance R2 between the upper detection pad DP_u and the third lower detection pad DP_l3 of the (n-1)-th horizontal misalignment detection circuit. In an embodiment, the n-th separation distance Rn having the largest separation distance between detection pads may be a times (a is a real number greater than 0 and less than 1) the unit length U_L of each of the upper detection pad DP_u, and the first to fourth lower detection pads DP_l1 to DP_l4.

In the horizontal misalignment detection circuits H_MDU of FIG. 12, for convenience of description, it is shown that the separation distances R1 to Rn between the upper detection pad DP_u and the first lower detection pad DP_l1 gradually increases along the opposite direction of the second direction D2, and the separation distances R1 and Rn between the lower detection pads DP_u and DP_l3 gradually decreases along the opposite direction of the second direction D2, but the scope of the present disclosure is not limited thereto. For example, the separation distances R1 to Rn between the upper detection pad DP_u and the first lower detection pad DP_l1 may gradually decrease along the opposite direction of the second direction D2, and the separation distances R1 to Rn between the upper detection pad DP_u and the third lower detection pad DP_l3 may gradually increase along the opposite direction of the second direction D2. In some embodiments, the first to n-th horizontal misalignment detection circuits H_MDU may be randomly arranged in the horizontal direction.

A separation distance between the upper detection pad DP_u and the second lower detection pad DP_l2 of the first to n-th vertical misalignment detection circuits V_MDU1 to V_MDUn may be different from each other. Referring to FIG. 12, the separation distances R1 to Rn between the upper detection pad DP_u and the second lower detection pad DP_l2 may increase along the opposite direction of the first direction D1. For example, the first separation distance R1 between the upper detection pad DP_u and the second lower detection pad DP_l2 of the first vertical misalignment detection circuit V_MDU1 may be the smallest distance, and the n-th separation distance Rn between the upper detection circuit DP_u and the second lower detection circuit DP_l2 of the n-th vertical misalignment detection circuit V_MDUn may be the largest distance.

Separation distances between the upper detection pad DP_u and the fourth lower detection pad DP_l4 of the first to n-th vertical misalignment detection circuits V_MDU1 to V_MDUn may be different from each other. Referring to FIG. 12, the separation distances R1 to Rn between the upper detection pad DP_u and the fourth lower detection pad DP_l4 may decrease along the opposite direction of the first direction D1. For example, a separation distance between the upper detection pad DP_u and the fourth lower detection pad DP_l4 of the first vertical misalignment detection circuit V_MDU1 may be the largest distance, and a separation distance between an upper bonding pad BP_u and the fourth lower bonding pad BP_l4 of the n-th vertical misalignment detection circuit V_MDUn may be the smallest distance.

In an embodiment, a ratio at which the separation distances R1 to Rn between the upper detection pad DP_u and the second lower detection pad DP_l2 increase may be the same as a ratio at which separation distances Rn to R1 between an upper detection pad DP_u and a fourth lower detection pad DP_l4 decrease. For example, the first separation distance R1 between the upper detection pad DP_u and the second lower detection pad DP_l2 of the first vertical misalignment detection circuit V_MDU1 may be the same as the first separation distance R1 between the upper detection pad DP_u and the fourth lower detection pad DP_l4 of the n-th vertical misalignment detection circuit V_MDUn. In some embodiments, the second separation distance R2 between the upper detection pad DP_u and the second lower detection pad DP_l2 of the second vertical misalignment detection circuit V_MDU2 may be the same as the second separation distances R2 between the upper detection pad DP_u and the fourth lower detection pad DP_l4 of the (n-1)-th vertical misalignment detection circuit.

The arrangement form of the vertical misalignment detection circuit V_MDU is not limited to the form shown in FIG. 12 as described in the horizontal misalignment detection circuit V_MDU.

According to an embodiment of the present disclosure, the test device may detect the presence or absence of misalignment in the horizontal direction and the misalignment length in the horizontal direction based on the horizontal misalignment detection circuits H_MDU. For example, the test device may detect the presence or absence of misalignment in the horizontal direction and the misalignment length in the horizontal direction based on the magnitude of the current flowing when the upper detection pad DP_u is connected to the first lower detection pad DP_l1 or the magnitude of the current flowing when the upper detection pad DP_u is connected to the third lower detection pad DP_l3.

In an embodiment, the test device may detect the presence or absence of misalignment in the vertical direction and the misalignment length in the vertical direction based on the vertical misalignment detection circuits V_MDU. For example, the test device may detect the presence or absence of misalignment in the vertical direction and the misalignment length in the vertical direction based on the magnitude of the current flowing when the upper detection pad DP_u is connected to the second lower detection pad DP_l2, or the magnitude of the current flowing when the lower detection pad DP_u is connected to the fourth lower detection pads DP_l4.

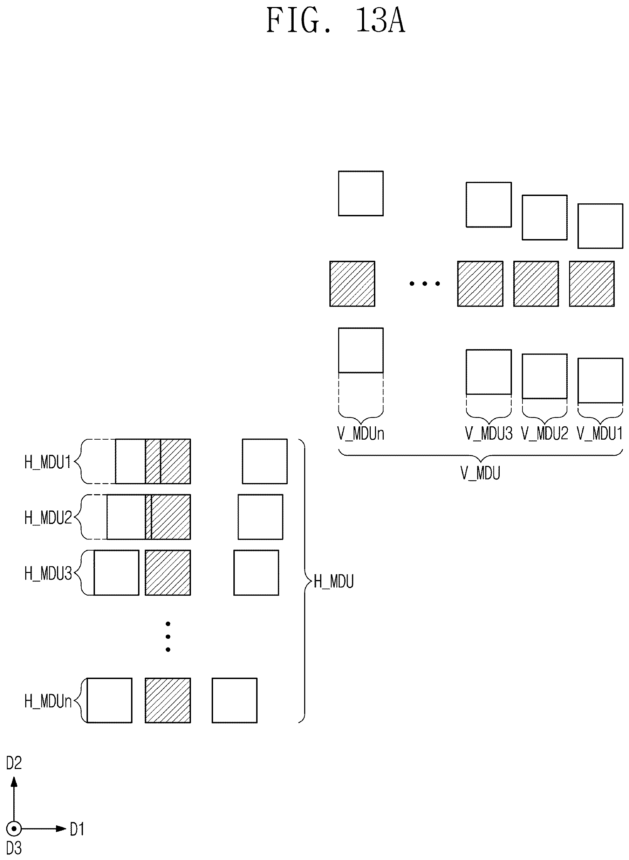

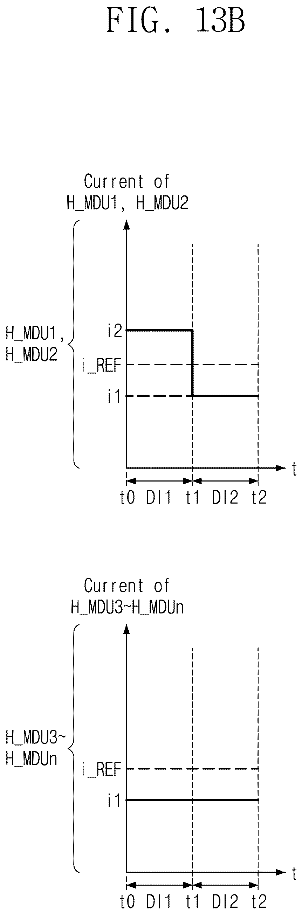

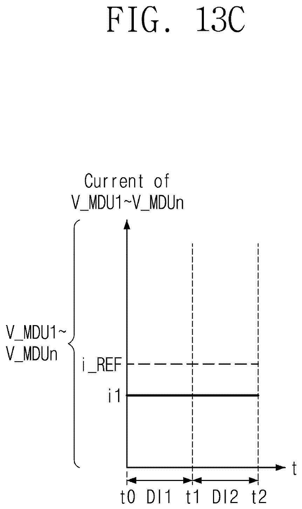

FIGS. 13A, 13B, and 13C are diagrams for describing misalignment detection circuits in which the horizontal direction is in a misalignment status, according to an embodiment.

Referring to FIG. 13A, some of the horizontal misalignment detection circuits H_MDU may be in a misalignment status. For example, the upper detection pad DP_u of the first and second horizontal misalignment detection circuits H_MDU1 and H_MDU2 may be connected to the first lower detection pad DP_l1. The upper detection pad DP_u of the third to n-th horizontal misalignment detection circuits H_MDU3 to H_MDUn may not be connected to the first lower detection pad DP_l1. That is, the first and second horizontal misalignment detection circuits H_MDU1 and H_MDU2 may be misaligned in the first direction D1, and the third to n-th horizontal misalignment detection circuits H_ MDU3 to H_MDUn may be in the normal-aligned status in the first direction D1.

The upper detection pad DP_u of the vertical misalignment detection circuits V_MDU may not be connected to both the second lower detection pad DP_l2 and the fourth lower detection padDP_l4, and thus may be in a normal-aligned state.

Referring to FIG. 13B, current flowing through the horizontal misalignment detection circuits H_MDU is illustrated, and referring to FIG. 13C, current flowing through vertical misalignment detection circuits V_MDU is shown.

The upper detection pad DP_u of the first and second horizontal misalignment detection circuits H_MDU1 and H_MDU2 may be connected to the first lower detection pad DP_l1. Therefore, the magnitude of the current flowing between the upper detection pad DP_u and the first lower detection pad DP_l1 of the first and second horizontal misalignment detection circuits H_MDU1 and H_MDU2 may be the second magnitude i2, and the second magnitude i2 may be greater than or equal to the reference magnitude i_REF. The magnitude of the current flowing through the upper detection pads and the third lower detection pads DP_l3 of the first and second horizontal misalignment detection circuits H_MDU1 and H_MDU2 may be the first magnitude i1, and the first magnitude i1 may be less than the reference magnitude i_REF.

The first and third lower detection pads DP_l1 and DP_l3 of the third to n-th horizontal misalignment detection circuits H_MDU3 to H_MDUn may not be connected to the upper detection pad DP_u. Therefore, the magnitude of the current flowing through the third to n-th horizontal misalignment detection circuits H_MDU3 to H_MDUn measured in the first to second measurement sections DI1 to DI2 may be the first magnitude i1. The second and fourth lower detection pads DP_l2, DP_l4 of the first to n-th vertical misalignment detection circuits V_MDU1 to V_MDUn may not be connected to the upper detection pad DP_u. Therefore, the magnitude of the current flowing through the first to n-th vertical misalignment detection circuits V_MDU1 to V_MDUn measured in the first to second measurement sections DI1 to DI2 may be the first magnitude i1. The first magnitude i1 may be less than the reference magnitude i_REF.

The test device according to an embodiment of the present disclosure may detect the misalignment direction and the misaligned length based on currents flowing through the first to fourth lower detection pads DP_l1 to DP_l4 of the horizontal misalignment detection circuits H_MDU and the vertical misalignment detection circuits V_MDU. For example, the test device may detect that the misalignment direction is a direction in which the first lower detection pad DP_l1 is disposed based on the magnitude of the current flowing through the first lower detection pad DP_l1 of the first and second horizontal misalignment detection circuits H_MDU1 and H_MDU2 being equal to or greater than the reference magnitude i_REF. In an embodiment, the test device may detect that the vertical misalignment has not occurred based on the magnitude of the current flowing through the vertical misalignment detection circuits V_MDU measured in the first to second measurement sections DI1 to DI2 being less than the reference magnitude i_REF. In an embodiment, the test device may detect a misalignment length based on the first and second horizontal misalignment detection circuits H_MDU1 and H_MDU2 in which misalignment has occurred. For example, it may be detected that the misalignment distance is the second separation distance R2 of the second horizontal misalignment detection circuit H_MDU2 having a long separation distance.

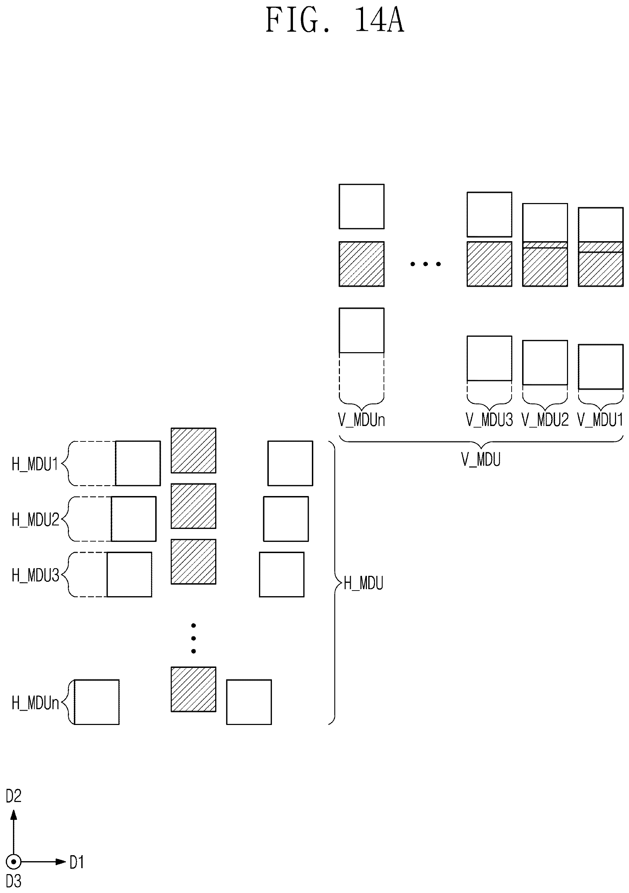

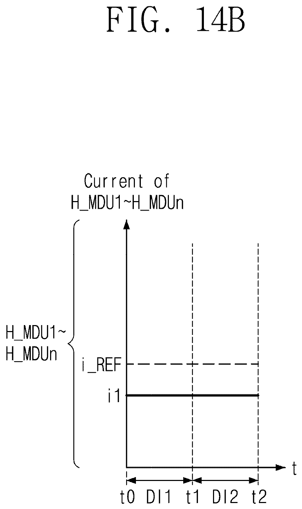

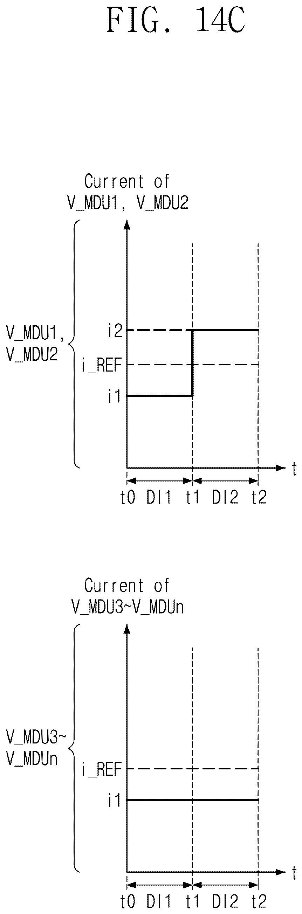

FIGS. 14A, 14B, and 14C are diagrams for describing misalignment detection circuits in which the vertical direction is in a misaligned status, according to an embodiment.

Referring to FIG. 14A, some of the vertical misalignment detection circuits V_MDU may be in a misaligned status. For example, the upper detection pad DP_u of the first and second vertical misalignment detection circuits V_MDU1 and V_MDU2 may be connected to the second lower detection pad DP_l2. The upper detection pads DP_u of the third to n-th vertical misalignment detection circuits V_MDU3 to V_MDUn may not be connected to the fourth lower detection pad DP_l4. That is, the first and second vertical misalignment detection circuits V_MDU1 and V_MDU2 may be in a misaligned status in the second direction D2, and the third to n-th vertical misalignment detection circuits V_ MDU3 to V_MDUn may be in the normal-aligned status in the second direction D2.

The upper detection pad DP_u of the horizontal misalignment detection circuits H_MDU may not be connected to both the first lower detection pad DP_l1 and the third lower detection pad DP_l3, and thus may be in a normal-aligned state.

Referring to FIG. 14B, current flowing through the horizontal misalignment detection circuits H_MDU is shown, and referring to FIG. 14C, current flowing through vertical misalignment detection circuits V_MDU is shown.

The first and third lower detection pads DP_l1, DP_13 of the first to n-th horizontal misalignment detection circuits H_MDU1 to H_MDUn may not be connected to the upper detection pad DP_u. Therefore, the magnitude of the current flowing through the first to n-th horizontal misalignment detection circuits H_MDU1 to H_MDUn measured in the first to second measurement sections DI1 to DI2 may be the first magnitude i1.

The upper detection pad DP_u of the first and second vertical misalignment detection circuits V_MDU1 and V_MDU2 may be connected to the second lower detection pad DP_l2. Therefore, the magnitude of the current flowing through the second lower detection pad DP_l2 of the first and second vertical misalignment detection circuits V_MDU1 and V_MDU2 may be the second magnitude i2, and the second magnitude i2 may be greater than or equal to the reference magnitude i_REF.

The second and fourth lower detection pads DP_l2, DP_l4 of the third to n-th vertical misalignment detection circuits V_MDU3 to V_MDUn may not be connected to the upper detection pad DP_u. Therefore, the magnitude of the current flowing through the third to n-th vertical misalignment detection circuits V_MDU3 to V_MDUn measured in the first to second measurement sections DI1 to DI2 may be the first magnitude i1. The first magnitude i1 may be less than the reference magnitude i_REF.

The test device according to an embodiment of the present disclosure may detect the misalignment direction and the misaligned length based on currents flowing through the first to fourth lower detection pads DP_l1 to DP_l4 of the horizontal misalignment detection circuits H_MDU and the vertical misalignment detection circuits V_MDU. For example, the test device may detect that the misalignment direction is a direction in which the second lower detection pad DP_l2 is disposed based on the magnitude of the current flowing through the second lower detection pad DP_l2 of the first and second vertical misalignment detection circuits V_MDU1 and V_MDU2 being equal to or greater than the reference magnitude i_REF. In an embodiment, the test device may detect that the horizontal misalignment has not occurred based on the magnitude of the current flowing through the first and third lower detection pads DP_l1, DP_l3 of the horizontal misalignment detection circuits H_MDU being less than the reference magnitude i_REF. In an embodiment, the test device may detect a misalignment distance based on the first and second vertical misalignment detection circuits V_MDU1 and V_MDU2 in which the misalignment has occurred. For example, it may be detected that the misalignment distance is the second separation distance R2 of the second vertical misalignment detection circuit V_MDU2 having the longest separation distance.

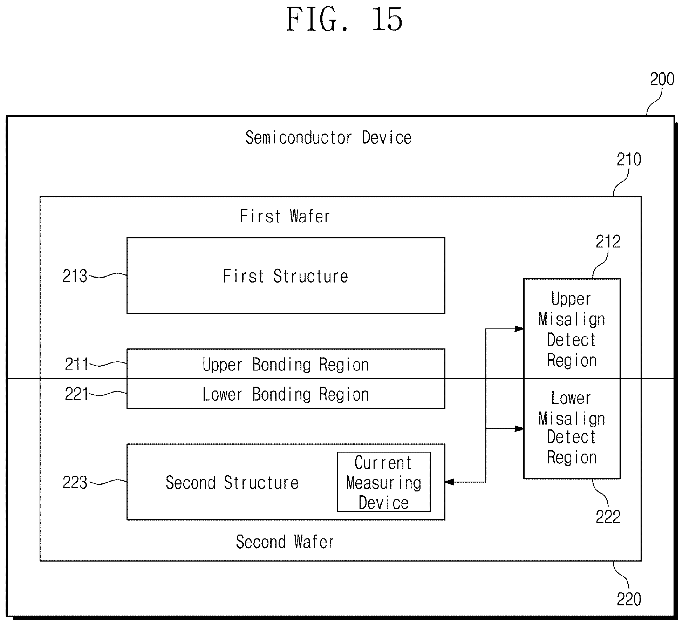

FIG. 15 is a diagram illustrating a semiconductor device according to an embodiment.

Referring to FIG. 15, the semiconductor device 200 may include a first wafer 210 and a second wafer 220. The first wafer 210 may include an upper bonding region 211, an upper misalignment detection region 212, and a first structure 213, and the second wafer 220 may include a lower bonding region 221, a lower misalignment detection region 222, and a second structure 223.

When the wafers are in the misaligned status in the W2W bonding process, the test device may determine whether the wafers are misaligned through the upper misalignment detection region 212 and the lower misalignment detection region 222. For example, the misalignment status may be determined based on a current flowing between an upper detection pad of the upper misalignment detection region 212 and a lower detection pad of a lower misalignment detection region 222.

The semiconductor device 200 may measure a current flowing between the upper misalignment detection region 212 and the lower misalignment detection region 222 through the second structure 223. For example, the second structure 223 may include a current measuring device, and the current measuring device may be connected with the upper misalignment detection 212 and the lower misalignment detection region 222.

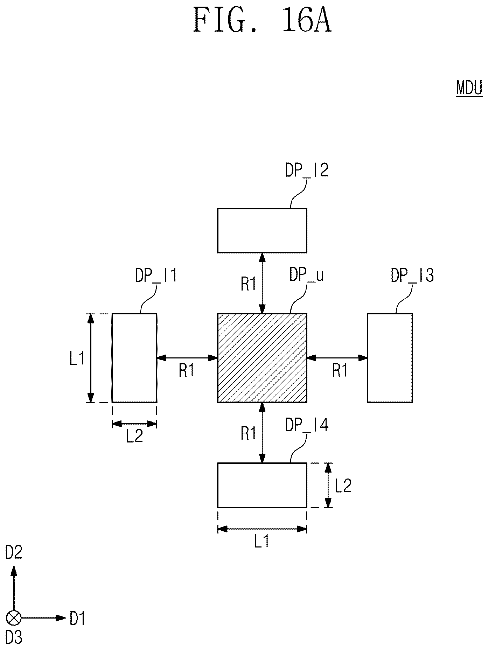

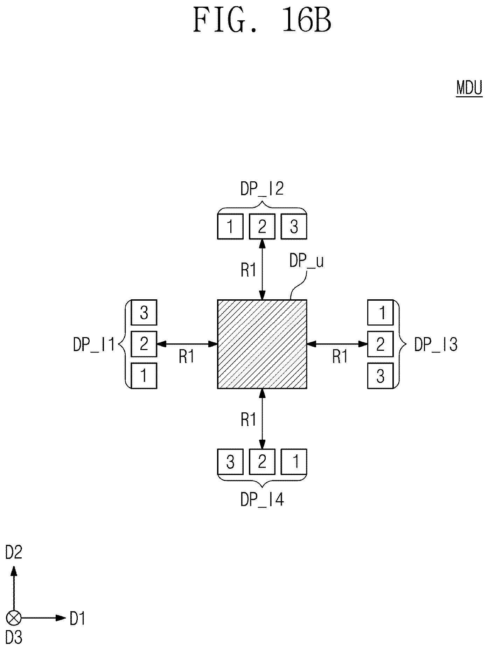

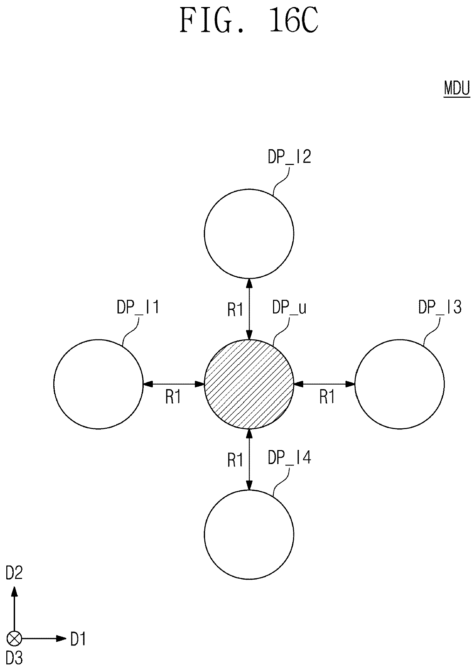

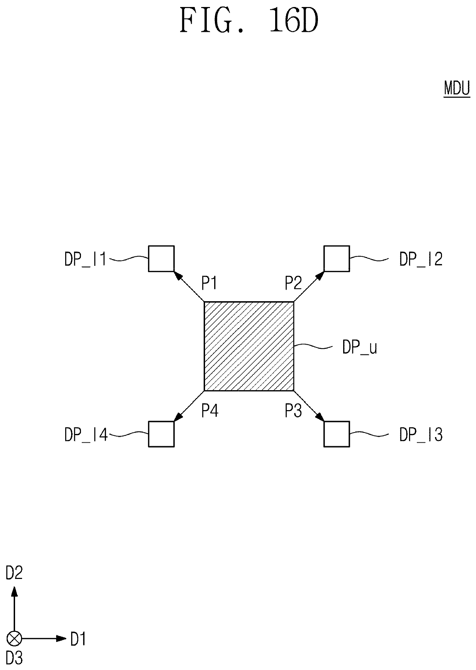

FIGS. 16A, 16B, 16C, and 16D are diagrams illustrating a misalignment detection circuit, according to some embodiments.

Referring first to FIG. 16A, the first to fourth lower detection pads DP_l1 to DP_l4 of the misalignment detection circuit MDU may have a rectangular shape. For example, a length of a long side of the first to fourth lower detection pads DP_l1 to DP_l4 may be a first length L1, and a length of a short side thereof may be a second length L2. The first length L1 may be the same as the length of the upper detection pad DP_u. The second length L2 may be shorter than the length of the upper detection pad DP_u. That is, as illustrated in FIG. 16A, when the first to fourth lower detection pads DP_l1 to DP_l4 are implemented in a rectangular shape, the area used to fabricate the lower detection pad can be reduced.

Next, referring to FIG. 16B, each of the first to fourth lower detection pads DP_l1 to DP_l4 of the misalignment detection circuit MDU may include a plurality of unit detection pads. Referring to FIG. 16B, each of the first to fourth lower detection pads DP_l1 to DP_l4 is shown to include three unit detection pads, but the number is merely illustrative.

As illustrated in FIG. 16B, when each of the plurality of lower detection pads DP_l1 to DP_l4 includes a plurality of unit detection pads, the test device may more accurately detect the misalignment direction. For example, the upper detection pad DP_u may be connected to the first unit detection pad and the second unit detection pad of the first lower detection pad DP_l1 and may not be connected to the third unit detection pad. In this case, the test device may detect that the magnitudes of the currents flowing through the first and second unit detection pads of the first lower detection pad DP_l1 are equal to or greater than the reference magnitude, and the magnitude of the current flowing through the third unit detection pad of the first lower detection pad DP_l1 is less than the reference magnitude. That is, the test device may detect that misalignment has occurred in a direction in which the first and second unit detection pads are disposed among the directions in which the first lower pad DP_l1 is disposed.

Next, referring to FIG. 16C, an upper detection circuit DP_u and first to fourth lower detection circuits DP_l1 to DP_l4 are illustrated. The shapes of the upper detection circuit DP_u and the first to third lower detection circuits DP_l1 to DP_l4 may be circular. For example, if a square detection pad is not formed for manufacturing process reasons, circular detection pads shown in FIG. 16C may be formed.

Finally, referring to FIG. 16D, each of the first to fourth lower detection pads DP_l1 to DP_l4 may be spaced apart from a vertex of the upper detection pad DP_u in the first to fourth directions P1 to P4.

As illustrated in FIG. 16D, the misalignment detection circuit MDU, in which the first to fourth lower detection pads DP_l1 to DP_l4 may be spaced apart from the vertex of the upper detection pad DP_u in the first to fourth directions P1 to P4, may more accurately detect a diagonal alignment status of the upper detection pad DP_u. For example, the misalignment detection circuit MDU shown in FIG. 16D may determine the alignment status in the first to fourth directions P1 toP4. That is, misalignment detection in diagonal directions may be easier.

FIG. 17 is a diagram illustrating the first wafer of FIG. 1, according to an embodiment.

Referring to FIG. 17, a first wafer 210 is shown. The first wafer 210 may include an upper bonding region 211 and a plurality of upper misalignment detection regions 212a to 212d. Referring to FIG. 17, a plurality of upper misalignment detection regions 212a to 212d are shown as four, but the scope of the present disclosure is not limited thereto, and the number may vary.

In an embodiment, some of the plurality of upper misalignment detection regions 212a to 212d may determine an aligned status in the first direction D1. For example, the a-th and b-th upper misalignment detection regions 212a and 212b may include the horizontal misalignment detection circuits H_MDU shown in FIG. 12. The a-th and b-th upper misalignment detection regions 212a and 212b may determine an aligned status in a first direction D1 between wafers based on the horizontal misalignment detection circuits.

In an embodiment, some of the plurality of upper misalignment detection regions 212a to 212d may determine an aligned status in the second direction D2. For example, the c-th and d-th upper misalignment detection regions 212c and 212d may include vertical misalignment detection circuits V_MDU shown in FIG. 12. The c-th and d-th top misalignment detection regions 212c and 212d may determine an aligned status in the second direction D2 between wafers based on the vertical misalignment detection circuits. However, the scope of the present disclosure is not limited thereto, and the number of the upper misalignment detection regions for detecting the aligned status in the horizontal direction or the vertical direction may vary.

In an embodiment, each of the plurality of upper misalignment detection regions 212a to 212d may detect an aligned status in which a separation distance between the upper detection pad and the lower detection pad is a specific value. For example, the a-th upper misalignment detection region 212a may detect an aligned status in which the separation distance is A times the unit length of the detection pad (where A is a real number greater than 0), the b-th upper misalignment detection region 212b may detect an aligned status in which the separation distance is B times the unit lengths of the detection pad (where B is a real number greater than 0), the c-th upper misalignment detection region 212c may detect an aligned status in which the separation distance is C times the unit length of the detection pad (where C is a real number less than 0), and the d-th upper misalignment detection region 212d may detect an aligned status in which the separation distance is D times the unit length of the detection pad (where D is a real number less than 0). Here, A to D may be different real numbers. That is, one upper misalignment detection region may be configured to detect an aligned status in which a separation distance between the upper detection pad and the lower detection pad is a specific value.

Although not shown in the figure, the second wafer 220 may also be configured to detect misalignment with respect to a specific direction or detect misalignments with respect to a particular spacing through a plurality of lower misalignment detection regions.

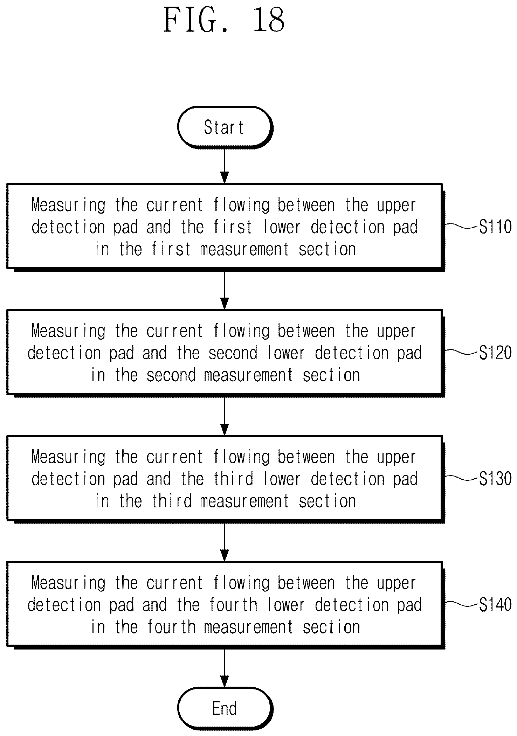

FIG. 18 is a flowchart for describing an operation of measuring a current flowing through the misalignment detection circuit, according to an embodiment. In an embodiment, the method may include operations S110 to S140 performed by the current measuring device 10.

Referring to FIGS. 1 to 4 and 18, in operation S110, the current measuring device 10 may measure a current flowing between the upper detection pad DP_u and the first lower detection pad DP_l1 in the first measurement section DI1. For example, at the first time point T0, the 0-th enable signal EN0 and the first enable signal EN1 may be applied to the 0-th transistor TR0 and the first transistor TR1, respectively. In the first measurement section DI1, the second to fourth enable signals EN2 to EN4 may not be applied to the second to fourth transistors TR2 to TR4, respectively.

In operation S120, the current measuring device 10 may measure a current flowing between the upper detection pad DP_u and the second lower detection pad DP_l2 in the second measurement section DI2. For example, at the first time point T1, the 0-th enable signal EN0 and the second enable signal EN2 may be applied to the 0-th transistor TR0 and the second transistor TR2, respectively. In the second measurement section DI2, the first, third, and fourth enable signals EN1, EN3, and EN4 may not be applied to the first, third and fourth transistors TR1, TR3, and TR4, respectively.

In operation S130, in operation S130, the current measuring device 10 may measure a current flowing between the upper detection pad DP_u and the third lower detection pad DP_l3 in the third measurement section DI3. For example, at the second time point T2, the 0-th enable signal EN0 and the third enable signal EN3 may be applied to the 0-th transistor TR0 and the third transistor TR3, respectively. In the third measurement section DI3, the first, second, and fourth enable signals EN1, EN2, and EN4 may not be applied to the first, second and fourth transistors TR1, TR3, and TR4, respectively.

In operation S140, the current measuring device 10 may measure a current flowing between the upper detection pad DP_u and the fourth lower detection pad DP_l4 in the fourth measurement section DI4. For example, at the third time point T3, the 0-th enable signal EN0 and the fourth enable signal EN4 may be applied to the 0-th transistor TR0 and the fourth transistor TR4, respectively. In the first measurement section DI1, the first to third enable signals EN1 to EN3 may not be applied to the first to third transistors TR1 to TR3, respectively.

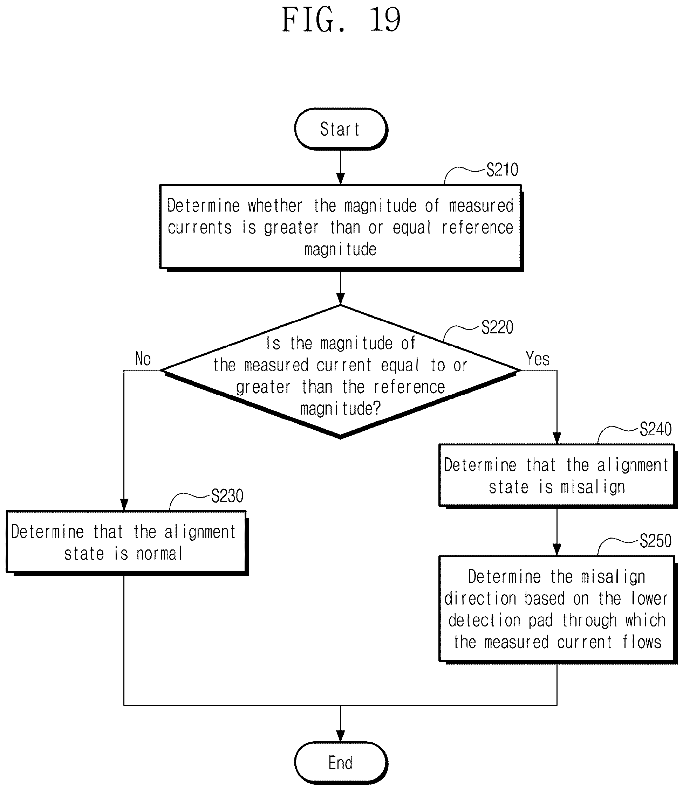

The current measuring device according to an embodiment of the present disclosure may measure a current for each of the plurality of misalignment detection circuits MDUs in a manner described in operations S110 to S140, and determine an aligned status of each of the misalignment detection circuits based on a measured current magnitude. The operation of determining the aligned status of each of the misalignment detection circuits will be described below with reference to FIG. 19.

FIG. 19 is a flowchart for describing an operation of determining an alignment status of the misalignment detection circuit based on the measured current. The operation of determining the alignment status of the misalignment detection circuit may be performed by a test device. For example, the test device may include a memory that stores program code and a processor that accesses the memory and executes the program code to cause the processor to perform operations S210 to S250. In some embodiments, the current measuring device 10 may be configured to perform the operations S210 to S250. For example, in some embodiments, the current measuring device 10 may include the memory and the processor configured to perform the operations S210 to S250.

Referring to FIGS. 1 to 4, 18, and 19, in operation S210, the test device may determine whether the magnitude of the measured currents is greater than or equal to the reference magnitude i_REF. For example, the test device may determine whether the magnitude of currents flowing between each of the lower detection pads DP_l1 to DP_l4 and the upper detection pad DP_u measured in the first to fourth measurement sections DI1 to DI4, respectively, is equal to or greater than the reference magnitude i_REF or is less than the reference magnitude i_REF.

When the magnitude of the measured current is less than the reference magnitude in the operation S220 (S220, No), operation S230 may be performed. In operation S230, when the magnitude of the measured currents is less than the reference magnitude i_REF, the test device may determine that the misalignment detection circuit MDU is in a normal-aligned status. For example, when the magnitudes of the currents measured in the first to fourth measurement sections DP_l1 to DP_l4 are all less than the reference magnitude i_REF, the test device may determine that the misalignment detection circuit MDU is in a normal-aligned status.

When the magnitude of the measured current is greater than or equal to the reference magnitude in the operation S220 (S220, Yes), operation S240 may be performed. In operation S240, when some of the magnitudes of the measured currents are greater than or equal to the reference magnitude i_REF, the test device may determine that the misalignment detection circuit MDU is in a misaligned status. For example, when some of the magnitudes of the currents measured in the first to fourth measurement sections DP_l1 to DP_l4 are the reference magnitude i_REF, the test device may determine that the misalignment detection circuit MDU is in a misaligned status.

In operation S250, the test device may determine the misalign direction based on the lower detection pad through which the second current flows. For example, the test device may determine a lower detection pad through which a current greater than or equal to the reference magnitude i_REF flows among the first to fourth lower detection pads DP_l1 to DP_l4. The test device may determine a direction in which a lower detection pad through which a current equal to or greater than the reference magnitude i_REF flows is disposed as a misalignment direction. The semiconductor device 100 according to an embodiment of the present disclosure may detect a misalignment direction and a misaligned distance based on an alignment status of each of a plurality of misalignment units.

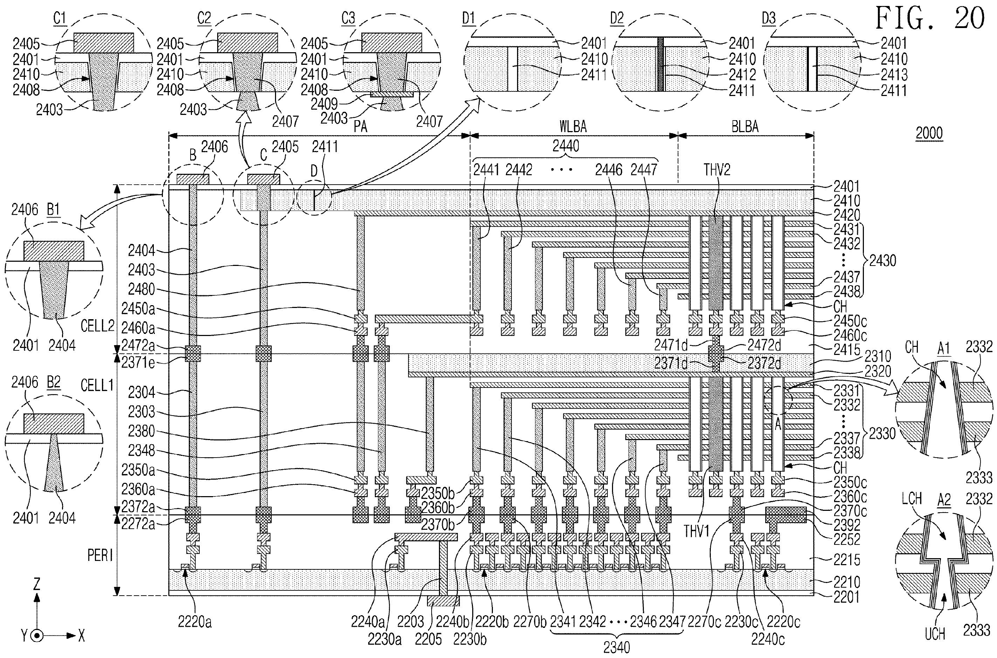

FIG. 20 is a view illustrating a memory device according to some embodiments.

Referring to FIG. 20, a memory device 2000 may have a chip-to-chip (C2C) structure. The C2C structure may refer a structure in which at least one upper chip including a cell region and a lower chip including a peripheral circuit region PERI are separately manufactured and connected to each other by a bonding method. For example, the bonding method may denote a method of electrically or physically connecting a bonding metal pattern formed in an uppermost metal layer of the upper chip to a bonding metal pattern formed in an uppermost metal layer of the lower chip. For example, in a case in which the bonding metal patterns are formed of copper (Cu), the bonding method may be a Cu-Cu bonding method. In some embodiments, the bonding metal patterns may be formed of aluminum (Al) or tungsten (W).

The memory device 2000 may include at least one upper chip including the cell region. For example, as illustrated in FIG. 20, the memory device 2000 may include two upper chips. However, the number of the upper chips is not limited thereto. In the case in which the memory device 2000 includes the two upper chips, a first upper chip including a first cell region CELL1, a second upper chip including a second cell region CELL2 and the lower chip including the peripheral circuit region PERI may be manufactured separately, and then, the first upper chip, the second upper chip and the lower chip may be connected to each other by the bonding method to manufacture the memory device 2000. The first upper chip may be turned over and then may be connected to the lower chip by the bonding method, and the second upper chip may also be turned over and then may be connected to the first upper chip by the bonding method. Hereinafter, upper and lower portions of each of the first and second upper chips will be defined based on before each of the first and second upper chips is turned over. In other words, an upper portion of the lower chip may mean an upper portion defined based on a +Z-axis direction, and the upper portion of each of the first and second upper chips may mean an upper portion defined based on a -Z-axis direction in FIG. 20. However, embodiments of the present disclosure are not limited thereto. In certain embodiments, one of the first upper chip and the second upper chip may be turned over and then may be connected to a corresponding chip by the bonding method.

Each of the peripheral circuit region PERI and the first and second cell regions CELL1 and CELL2 of the memory device 2000 may include an external pad bonding region PA, a word line bonding region WLBA, and a bit line bonding region BLBA.

The peripheral circuit region PERI may include a first substrate 2210 and a plurality of circuit elements 2220a, 2220b and 2220c formed on the first substrate 2210. An interlayer insulating layer 2215 including one or more insulating layers may be provided on the plurality of circuit elements 2220a, 2220b and 2220c, and a plurality of metal lines electrically connected to the plurality of circuit elements 2220a, 2220b and 2220c may be provided in the interlayer insulating layer 2215. For example, the plurality of metal lines may include first metal lines 2230a, 2230b and 2230c connected to the plurality of circuit elements 2220a, 2220b and 2220c, and second metal lines 2240a, 2240b and 2240c formed on the first metal lines 2230a, 2230b and 2230c. The plurality of metal lines may be formed of at least one of various conductive materials. For example, the first metal lines 2230a, 2230b and 2230c may be formed of tungsten having a relatively high electrical resistivity, and the second metal lines 2240a, 2240b and 2240c may be formed of copper having a relatively low electrical resistivity.

The first metal lines 2230a, 2230b and 2230c and the second metal lines 2240a, 2240b and 2240c are illustrated and described in the present embodiments. However, embodiments of the present disclosure are not limited thereto. In certain embodiments, at least one or more additional metal lines may further be formed on the second metal lines 2240a, 2240b and 2240c. In this case, the second metal lines 2240a, 2240b and 2240c may be formed of aluminum, and at least some of the additional metal lines formed on the second metal lines 2240a, 2240b and 2240c may be formed of copper having an electrical resistivity lower than that of aluminum of the second metal lines 2240a, 2240b and 2240c.

The interlayer insulating layer 2215 may be disposed on the first substrate 2210 and may include an insulating material such as silicon oxide and/or silicon nitride.

Each of the first and second cell regions CELL1 and CELL2 may include at least one memory block. The first cell region CELL1 may include a second substrate 2310 and a common source line 2320. A plurality of word lines 2330 (2331 to 2338) may be stacked on the second substrate 2310 in a direction (i.e., the Z-axis direction) perpendicular to a top surface of the second substrate 2310. String selection lines and a ground selection line may be disposed on and under the word lines 2330, and the plurality of word lines 2330 may be disposed between the string selection lines and the ground selection line. Likewise, the second cell region CELL2 may include a third substrate 2410 and a common source line 2420, and a plurality of word lines 2430 (2431 to 2438) may be stacked on the third substrate 2410 in a direction (i.e., the Z-axis direction) perpendicular to a top surface of the third substrate 2410. Each of the second substrate 2310 and the third substrate 2410 may be formed of at least one of various materials and may be, for example, a silicon substrate, a silicon-germanium substrate, a germanium substrate, or a substrate having a single-crystalline epitaxial layer grown on a single-crystalline silicon substrate. A plurality of channel structures CH may be formed in each of the first and second cell regions CELL1 and CELL2.

In some embodiments, as illustrated in a region 'A1', the channel structure CH may be provided in the bit line bonding region BLBA and may extend in the direction perpendicular to the top surface of the second substrate 2310 to penetrate the word lines 2330, the string selection lines, and the ground selection line. The channel structure CH may include a data storage layer, a channel layer, and a filling insulation layer. The channel layer may be electrically connected to a first metal line 2350c and a second metal line 2360c in the bit line bonding region BLBA. For example, the second metal line 2360c may be a bit line and may be connected to the channel structure CH through the first metal line 2350c. The bit line 2360c may extend in a first direction (e.g., a Y-axis direction) parallel to the top surface of the second substrate 2310.

In some embodiments, as illustrated in a region 'A2', the channel structure CH may include a lower channel LCH and an upper channel UCH, which are connected to each other. For example, the channel structure CH may be formed by a process of forming the lower channel LCH and a process of forming the upper channel UCH. The lower channel LCH may extend in the direction perpendicular to the top surface of the second substrate 2310 to penetrate the common source line 2320 and lower word lines 2331 and 2332. The lower channel LCH may include a data storage layer, a channel layer, and a filling insulation layer and may be connected to the upper channel UCH. The upper channel UCH may penetrate upper word lines 2333 to 2338. The upper channel UCH may include a data storage layer, a channel layer, and a filling insulation layer, and the channel layer of the upper channel UCH may be electrically connected to the first metal line 2350c and the second metal line 2360c. As a length of a channel increases, due to characteristics of manufacturing processes, it may be difficult to form a channel having a substantially uniform width. The memory device 2000 according to the embodiment illustrated in FIG. 20 may include a channel having improved width uniformity due to the lower channel LCH and the upper channel UCH which are formed by the processes performed sequentially.

In the case in which the channel structure CH includes the lower channel LCH and the upper channel UCH as illustrated in the region 'A2', a word line located near to a boundary between the lower channel LCH and the upper channel UCH may be a dummy word line. For example, the word lines 2332 and 2333 adjacent to the boundary between the lower channel LCH and the upper channel UCH may be the dummy word lines. In this case, data may not be stored in memory cells connected to the dummy word line. In some embodiments, the number of pages corresponding to the memory cells connected to the dummy word line may be less than the number of pages corresponding to the memory cells connected to a general word line. A level of a voltage applied to the dummy word line may be different from a level of a voltage applied to the general word line, and thus it is possible to reduce an influence of a non-uniform channel width between the lower and upper channels LCH and UCH on an operation of the memory device.

The number of the lower word lines 2331 and 2332 penetrated by the lower channel LCH is less than the number of the upper word lines 2333 to 2338 penetrated by the upper channel UCH in the region 'A2'. However, embodiments of the present disclosure are not limited thereto. In certain embodiments, the number of the lower word lines penetrated by the lower channel LCH may be equal to or more than the number of the upper word lines penetrated by the upper channel UCH. In an embodiment, structural features and connection relation of the channel structure CH disposed in the second cell region CELL2 may be substantially the same as those of the channel structure CH disposed in the first cell region CELL1.

In the bit line bonding region BLBA, a first through-electrode THV1 may be provided in the first cell region CELL1, and a second through-electrode THV2 may be provided in the second cell region CELL2. As illustrated in FIG. 20, the first through-electrode THV1 may penetrate the common source line 2320 and the plurality of word lines 2330. In certain embodiments, the first through-electrode THV1 may further penetrate the second substrate 2310. The first through-electrode THV1 may include a conductive material. In some embodiments, the first through-electrode THV1 may include a conductive material surrounded by an insulating material. The second through-electrode THV2 may have the same shape and structure as the first through-electrode THV1. The second through-electrode THV2 may be electrically connected to a first metal line 2450c and a second metal line 2460c.

In some embodiments, the first through-electrode THV1 and the second through-electrode THV2 may be electrically connected to each other through a first through-metal pattern 2372d and a second through-metal pattern 2472d. The first through-metal pattern 2372d may be formed at a bottom end of the first upper chip including the first cell region CELL1, and the second through-metal pattern 2472d may be formed at a top end of the second upper chip including the second cell region CELL2. The first through-electrode THV1 may be electrically connected to the first metal line 2350c and the second metal line 2360c. A lower via 2371d may be formed between the first through-electrode THV1 and the first through-metal pattern 2372d, and an upper via 2471d may be formed between the second through-electrode THV2 and the second through-metal pattern 2472d. The first through-metal pattern 2372d and the second through-metal pattern 2472d may be connected to each other by the bonding method.

In an embodiment, in the bit line bonding region BLBA, an upper metal pattern 2252 may be formed in an uppermost metal layer of the peripheral circuit region PERI, and an upper metal pattern 2392 having the same shape as the upper metal pattern 2252 may be formed in an uppermost metal layer of the first cell region CELL1. The upper metal pattern 2392 of the first cell region CELL1 and the upper metal pattern 2252 of the peripheral circuit region PERI may be electrically connected to each other by the bonding method. In the bit line bonding region BLBA, the bit line 2360c may be electrically connected to a page buffer included in the peripheral circuit region PERI. For example, some of the circuit elements 2220c of the peripheral circuit region PERI may constitute the page buffer, and the bit line 2360c may be electrically connected to the circuit elements 2220c constituting the page buffer through an upper bonding metal pattern 2370c of the first cell region CELL1 and an upper bonding metal pattern 2270c of the peripheral circuit region PERI.

Referring to FIG. 20, in the word line bonding region WLBA, the word lines 2330 of the first cell region CELL1 may extend in a second direction (e.g., an X-axis direction) parallel to the top surface of the second substrate 2310 and may be connected to a plurality of cell contact plugs 2340 (2341 to 2347). First metal lines 2350b and second metal lines 2360b may be sequentially connected onto the cell contact plugs 2340 connected to the word lines 2330. In the word line bonding region WLBA, the cell contact plugs 2340 may be connected to the peripheral circuit region PERI through upper bonding metal patterns 2370b of the first cell region CELL1 and upper bonding metal patterns 2270b of the peripheral circuit region PERI.

The cell contact plugs 2340 may be electrically connected to a row decoder included in the peripheral circuit region PERI. For example, some of the circuit elements 2220b of the peripheral circuit region PERI may provide the row decoder, and the cell contact plugs 2340 may be electrically connected to the circuit elements 2220b providing the row decoder through the upper bonding metal patterns 2370b of the first cell region CELL1 and the upper bonding metal patterns 2270b of the peripheral circuit region PERI. In some embodiments, an operating voltage of the circuit elements 2220b constituting the row decoder may be different from an operating voltage of the circuit elements 2220c constituting the page buffer. For example, the operating voltage of the circuit elements 2220c providing the page buffer may be greater than the operating voltage of the circuit elements 2220b constituting the row decoder.

Likewise, in the word line bonding region WLBA, the word lines 2430 of the second cell region CELL2 may extend in the second direction (e.g., the X-axis direction) parallel to the top surface of the third substrate 2410 and may be connected to a plurality of cell contact plugs 2440 (2441 to 2447). The cell contact plugs 2440 may be connected to the peripheral circuit region PERI through an upper metal pattern of the second cell region CELL2 and lower and upper metal patterns and a cell contact plug 2348 of the first cell region CELL1.

In the word line bonding region WLBA, the upper bonding metal patterns 2370b may be formed in the first cell region CELL1, and the upper bonding metal patterns 2270b may be formed in the peripheral circuit region PERI. The upper bonding metal patterns 2370b of the first cell region CELL1 and the upper bonding metal patterns 2270b of the peripheral circuit region PERI may be electrically connected to each other by the bonding method. The upper bonding metal patterns 2370b and the upper bonding metal patterns 2270b may be formed of aluminum, copper, or tungsten.

In the external pad bonding region PA, a lower metal pattern 2371e may be formed in a lower portion of the first cell region CELL1, and an upper metal pattern 2472a may be formed in an upper portion of the second cell region CELL2. The lower metal pattern 2371e of the first cell region CELL1 and the upper metal pattern 2472a of the second cell region CELL2 may be connected to each other by the bonding method in the external pad bonding region PA. Likewise, an upper metal pattern 2372a may be formed in an upper portion of the first cell region CELL1, and an upper metal pattern 2272a may be formed in an upper portion of the peripheral circuit region PERI. The upper metal pattern 2372a of the first cell region CELL1 and the upper metal pattern 2272a of the peripheral circuit region PERI may be connected to each other by the bonding method.

Common source line contact plugs 2380 and 2480 may be disposed in the external pad bonding region PA. The common source line contact plugs 2380 and 2480 may be formed of a conductive material such as a metal, a metal compound, and/or doped polysilicon. The common source line contact plug 2380 of the first cell region CELL1 may be electrically connected to the common source line 2320, and the common source line contact plug 2480 of the second cell region CELL2 may be electrically connected to the common source line 2420. A first metal line 2350a and a second metal line 2360a may be sequentially stacked on the common source line contact plug 2380 of the first cell region CELL1, and a first metal line 2450a and a second metal line 2460a may be sequentially stacked on the common source line contact plug 2480 of the second cell region CELL2.

Input/output pads 2205, 2405 and 2406 may be disposed in the external pad bonding region PA. Referring to FIG. 20, a lower insulating layer 2201 may cover a bottom surface of the first substrate 2210, and a first input/output pad 2205 may be formed on the lower insulating layer 2201. The first input/output pad 2205 may be connected to at least one of a plurality of the circuit elements 2220a disposed in the peripheral circuit region PERI through a first input/output contact plug 2203 and may be separated from the first substrate 2210 by the lower insulating layer 2201. In an embodiment, a side insulating layer may be disposed between the first input/output contact plug 2203 and the first substrate 2210 to electrically isolate the first input/output contact plug 2203 from the first substrate 2210.

An upper insulating layer 2401 covering a top surface of the third substrate 2410 may be formed on the third substrate 2410. A second input/output pad 2405 and/or a third input/output pad 2406 may be disposed on the upper insulating layer 2401. The second input/output pad 2405 may be connected to at least one of the plurality of circuit elements 2220a disposed in the peripheral circuit region PERI through second input/output contact plugs 2403 and 2303, and the third input/output pad 2406 may be connected to at least one of the plurality of circuit elements 2220a disposed in the peripheral circuit region PERI through third input/output contact plugs 2404 and 2304.

In some embodiments, the third substrate 2410 may not be disposed in a region in which the input/output contact plug is disposed. For example, as illustrated in a region 'B', the third input/output contact plug 2404 may be separated from the third substrate 2410 in a direction parallel to the top surface of the third substrate 2410 and may penetrate an interlayer insulating layer 2415 of the second cell region CELL2 so as to be connected to the third input/output pad 2406. In this case, the third input/output contact plug 2404 may be formed by at least one of various processes.

In some embodiments, as illustrated in a region 'B1', the third input/output contact plug 2404 may extend in a third direction (e.g., the Z-axis direction), and a diameter of the third input/output contact plug 2404 may become progressively greater toward the upper insulating layer 2401. In other words, a diameter of the channel structure CH described in the region 'Al' may become progressively less toward the upper insulating layer 2401, but the diameter of the third input/output contact plug 2404 may become progressively greater toward the upper insulating layer 2401. For example, the third input/output contact plug 2404 may be formed after the second cell region CELL2 and the first cell region CELL1 are bonded to each other by the bonding method.

In certain embodiments, as illustrated in a region 'B2', the third input/output contact plug 2404 may extend in the third direction (e.g., the Z-axis direction), and a diameter of the third input/output contact plug 2404 may become progressively less toward the upper insulating layer 2401. In other words, like the channel structure CH, the diameter of the third input/output contact plug 2404 may become progressively less toward the upper insulating layer 2401. For example, the third input/output contact plug 2404 may be formed together with the cell contact plugs 2440 before the second cell region CELL2 and the first cell region CELL1 are bonded to each other.

In certain embodiments, the input/output contact plug may overlap with the third substrate 2410. For example, as illustrated in a region 'C', the second input/output contact plug 2403 may penetrate the interlayer insulating layer 2415 of the second cell region CELL2 in the third direction (e.g., the Z-axis direction) and may be electrically connected to the second input/output pad 2405 through the third substrate 2410. In this case, a connection structure of the second input/output contact plug 2403 and the second input/output pad 2405 may be realized by various methods.

In some embodiments, as illustrated in a region 'C1', an opening 2408 may be formed to penetrate the third substrate 2410, and the second input/output contact plug 2403 may be connected directly to the second input/output pad 2405 through the opening 2408 formed in the third substrate 2410. In this case, as illustrated in the region 'C1', a diameter of the second input/output contact plug 2403 may become progressively greater toward the second input/output pad 2405. However, embodiments of the present disclosure are not limited thereto, and in certain embodiments, the diameter of the second input/output contact plug 2403 may become progressively less toward the second input/output pad 2405.

In certain embodiments, as illustrated in a region 'C2', the opening 2408 penetrating the third substrate 2410 may be formed, and a contact 2407 may be formed in the opening 2408. An end of the contact 2407 may be connected to the second input/output pad 2405, and another end of the contact 2407 may be connected to the second input/output contact plug 2403. Thus, the second input/output contact plug 2403 may be electrically connected to the second input/output pad 2405 through the contact 2407 in the opening 2408. In this case, as illustrated in the region 'C2', a diameter of the contact 2407 may become progressively greater toward the second input/output pad 2405, and a diameter of the second input/output contact plug 2403 may become progressively less toward the second input/output pad 2405. For example, the second input/output contact plug 2403 may be formed together with the cell contact plugs 2440 before the second cell region CELL2 and the first cell region CELL1 are bonded to each other, and the contact 2407 may be formed after the second cell region CELL2 and the first cell region CELL1 are bonded to each other.

In certain embodiments illustrated in a region 'C3', a stopper 2409 may further be formed on a bottom end of the opening 2408 of the third substrate 2410, as compared with the embodiments of the region 'C2'. The stopper 2409 may be a metal line formed in the same layer as the common source line 2420. In some embodiments, the stopper 2409 may be a metal line formed in the same layer as at least one of the word lines 2430. The second input/output contact plug 2403 may be electrically connected to the second input/output pad 2405 through the contact 2407 and the stopper 2409.

Like the second and third input/output contact plugs 2403 and 2404 of the second cell region CELL2, a diameter of each of the second and third input/output contact plugs 2303 and 2304 of the first cell region CELL1 may become progressively less toward the lower metal pattern 2371e or may become progressively greater toward the lower metal pattern 2371e.

In some embodiments, a slit 2411 may be formed in the third substrate 2410. For example, the slit 2411 may be formed at a certain position of the external pad bonding region PA. For example, as illustrated in a region 'D', the slit 2411 may be located between the second input/output pad 2405 and the cell contact plugs 2440 when viewed in a plan view. In some embodiments, the second input/output pad 2405 may be located between the slit 2411 and the cell contact plugs 2440 when viewed in a plan view.

In some embodiments, as illustrated in a region 'D1', the slit 2411 may be formed to penetrate the third substrate 2410. For example, the slit 2411 may be used to prevent the third substrate 2410 from being finely cracked when the opening 2408 is formed. However, embodiments of the present disclosure are not limited thereto, and in certain embodiments, the slit 2411 may be formed to have a depth ranging from about 60% to about 70% of a thickness of the third substrate 2410.

In certain embodiments, as illustrated in a region 'D2', a conductive material 2412 may be formed in the slit 2411. For example, the conductive material 2412 may be used to discharge a leakage current occurring in driving of the circuit elements in the external pad bonding region PA to the outside. In this case, the conductive material 2412 may be connected to an external ground line.

In certain embodiments, as illustrated in a region 'D3', an insulating material 2413 may be formed in the slit 2411. For example, the insulating material 2413 may be used to electrically isolate the second input/output pad 2405 and the second input/output contact plug 2403 disposed in the external pad bonding region PA from the word line bonding region WLBA. Since the insulating material 2413 is formed in the slit 2411, it is possible to prevent a voltage provided through the second input/output pad 2405 from affecting a metal layer disposed on the third substrate 2410 in the word line bonding region WLBA.

In certain embodiments, the first to third input/output pads 2205, 2405 and 2406 may be selectively formed. For example, the memory device 2000 may be realized to include only the first input/output pad 2205 disposed on the first substrate 2210, to include only the second input/output pad 2405 disposed on the third substrate 2410, or to include only the third input/output pad 2406 disposed on the upper insulating layer 2401.

In some embodiments, at least one of the second substrate 2310 of the first cell region CELL1 or the third substrate 2410 of the second cell region CELL2 may be used as a sacrificial substrate and may be completely or partially removed before or after a bonding process. An additional layer may be stacked after the removal of the substrate. For example, the second substrate 2310 of the first cell region CELL1 may be removed before or after the bonding process of the peripheral circuit region PERI and the first cell region CELL1, and then, an insulating layer covering a top surface of the common source line 2320 or a conductive layer for connection may be formed. Likewise, the third substrate 2410 of the second cell region CELL2 may be removed before or after the bonding process of the first cell region CELL1 and the second cell region CELL2, and then, the upper insulating layer 2401 covering a top surface of the common source line 2420 or a conductive layer for connection may be formed.

In an embodiment, the misalignment detection regions 112, 122, 212, and 222 described in FIG. 1 or FIG. 15 may be implemented in the first cell region CELL1 and the second cell region CELL1 of FIG. 20. In some embodiments, the misalignment detection regions 112, 122, 212, and 222 may be implemented in the first cell region CELL1 and the peripheral circuit region PRI. Accordingly, the test device according to an embodiment of the present disclosure may determine whether the alignment status of the first cell region CELL1 and the second cell region CELL1, through the misalignment detection regions 112 and 122, is a normal-aligned status or a misaligned state. In some embodiments, the test device may determine whether the aligned status of the first cell region CELL1 and the peripheral circuit region PERI is a normal-aligned status or a misaligned status through the misalignment detection regions 112 and 122.

In an embodiment, when it is determined that the aligned status is a misaligned status, the test device may determine the misalignment direction and misalignment length through the misalignment detection regions 112 and 122. The test device may provide feedback for the W2W bonding process based on the determined misalignment direction and misalignment length. For example, when the misalignment direction is left, feedback may be provided so that the alignment direction of the first wafer 110, the first cell region CELL1, the second cell region CELL2, and the like is right. In some embodiments, when it is determined that the misalignment length is the first separation distance, feedback may be provided to move in the forward direction by the first separation distance.

Embodiments are set out in the following clauses:
Clause 1. A semiconductor device comprising: a first wafer including a first upper detection pad and a second upper detection pad; and a second wafer including a first lower detection pad and a second lower detection pad, the first wafer being bonded to the second wafer, when the first wafer and the second wafer are bonded on a plane formed by the first wafer and the second wafer, the first upper detection pad and the first lower detection pad are spaced apart from each other by a first separation distance on the plane, and the second upper detection pad and the second lower detection pad are spaced apart from each other by a second separation distance on the plane, the second separation distance being different from the first separation distance, and wherein an alignment status between the first wafer and the second wafer is determined based on a current flowing when the first upper detection pad and the second upper detection pad and the first lower detection pad and the second lower detection pad are connected to each other.
Clause 2. The semiconductor device of Clause 1, wherein the first wafer further comprises upper bonding pads, wherein the second wafer further comprises lower bonding pads, and wherein when the first wafer and the second wafer are bonded, the upper bonding pads and the lower bonding pads are respectively electrically connected to each other on the plane.
Clause 3. The semiconductor device of Clause 1 or 2, wherein the first wafer further comprises a first upper transistor and a second upper transistor, wherein the second wafer further comprises a first lower transistor and a second lower transistor, and wherein one terminal of the first upper transistor is electrically connected to the first upper detection pad and one terminal of the second upper transistor is electrically connected to the second upper detection pad, and one terminal of the first lower transistor is electrically connected to the first lower detection pad and one terminal of the second lower transistor is electrically connected to the second lower detection pad.
Clause 4. The semiconductor device of Clause 3, wherein another terminal of the first upper transistor and another terminal of the second upper transistor are electrically connected to a power supply voltage, and wherein another terminal of the first lower transistor and another terminal of the second lower transistor are electrically connected to a ground voltage.
Clause 5. The semiconductor device of any preceding Clause, wherein when the first wafer and the second wafer are misaligned on the plane, the first upper detection pad is electrically connected to the first lower detection pad, and the second upper detection pad is not electrically connected to the second lower detection pad.
Clause 6. The semiconductor device of any preceding Clause, wherein the second wafer further comprises a third lower detection pad and a fourth lower detection pad, wherein when the first wafer and the second wafer are bonded on the plane, the first upper detection pad is spaced apart from the third lower detection pad by the first separation distance on the plane, and the second upper detection pad is spaced apart from the fourth lower detection pad by the second separation distance on the plane, wherein the first lower detection pad is disposed in a first direction from the first upper detection pad, and the second lower detection pad is disposed in the first direction from the second upper detection pad, and the third lower detection pad is disposed in a second direction from the first upper detection pad, the second direction different from the first direction, and the fourth lower detection pad is disposed in the second direction from the second upper detection pad.
Clause 7. The semiconductor device of Clause 6, wherein the first direction is orthogonal to the second direction.
Clause 8. The semiconductor device of Clause 6, wherein the first direction is opposite to the second direction.
Clause 9. The semiconductor device of Clause 6, wherein when the first wafer and the second wafer are misaligned on the plane, the first upper detection pad is electrically connected to the first lower detection pad, the first upper detection pad is not electrically connected to the third lower detection pad, the second upper detection pad is not electrically connected to the second lower detection pad, and the second upper detection pad is not electrically connected to the fourth lower detection pad.
Clause 10. The semiconductor device of Clause 6, wherein when the first wafer and the second wafer are misaligned on the plane, the first upper detection pad is electrically connected to the first lower detection pad, the first upper detection pad is electrically connected to the third lower detection pad, the second upper detection pad is not electrically connected to the second lower detection pad, and the second upper detection pad is not electrically connected to the fourth lower detection pad.
Clause 11. A semiconductor device comprising: a first wafer including a first upper detection pad, a second upper detection pad, a third upper detection pad, and a fourth upper detection pad; and a second wafer including a first lower detection pad, a second lower upper detection pad, a third lower detection pad, and a fourth lower detection pad, wherein the first wafer is bonded to the second wafer, wherein when the first wafer and the second wafer are bonded on a plane formed by the first wafer and the second wafer, the first upper detection pad is spaced apart from the first lower detection pad by a first separation distance, the second upper detection pad is spaced apart from the second lower detection pad by a second separation distance that is different from the first separation distance, the third upper detection pad is spaced apart from the third lower detection pad by the first separation distance, and the fourth upper detection pad is spaced apart from the fourth lower detection pad by the second separation distance, wherein the first lower detection pad is disposed in a first direction from the first upper detection pad, wherein the second lower detection pad is disposed in the first direction from the second upper detection pad, wherein the third lower detection pad is disposed in a second direction from the third upper detection pad, the second direction different from the first direction, wherein the fourth lower detection pad is disposed in the second direction from the fourth upper detection pad, and wherein an aligned status between the first wafer and the second wafer is determined based on a current flowing when the first upper detection pad, the second upper detection pad, the third upper detection pad, and the fourth upper detection pad are connected to the first lower detection pad, the second lower detection pad, the third lower detection pad, and the fourth lower detection pad.
Clause 12. The semiconductor device of Clause 11, wherein the first direction is orthogonal to the second direction.
Clause 13. The semiconductor device of Clause 11, wherein the first direction is opposite to the second direction.
Clause 14. The semiconductor device of Clause 11, 12 or 13, wherein the first wafer further comprises upper bonding pads, wherein the second wafer further comprises lower bonding pads, and wherein when the first wafer and the second wafer are bonded, the upper bonding pads are respectively electrically connected to the lower bonding pads on the plane.
Clause 15. The semiconductor device of Clause 11, 12, 13 or 14, wherein the first wafer further comprises a first upper transistor, a second upper transistor, a third upper transistor, and a fourth upper transistor, wherein the second wafer further comprises a first lower transistor, a second lower transistor, a third lower transistor, and a fourth lower transistor, and wherein one terminal of each of the first upper transistor, the second upper transistor, the third upper transistor, and the fourth upper transistor is electrically connected to the first upper detection pad, the second upper detection pad, the third upper detection pad, and the fourth upper detection pad, respectively, and one terminal of each of the first lower transistor, the second lower transistor, the third lower transistor, and the fourth lower transistor is electrically connected to the first lower detection pad, the second lower detection pad, the third lower detection pad, and the fourth lower detection pad, respectively.
Clause 16. The semiconductor device of Clause 15, wherein another terminal of each of the first upper transistor, the second upper transistor, the third upper transistor, and the fourth upper transistor are electrically connected to a power supply voltage, and wherein another terminal of each of the first lower transistor, the second lower transistor, the third lower transistor, and the fourth lower transistor are electrically connected to a ground voltage.
Clause 17. The semiconductor device of any of Clauses 11 to 16, wherein when the first wafer and the second wafer are misaligned on the plane, the first upper detection pad is electrically connected to the first lower detection pad, the second upper detection pad is not electrically connected to the second lower detection pad, the third upper detection pad is not electrically connected to the third lower detection pad, and the fourth upper detection pad is not electrically connected to the fourth lower detection pad.
Clause 18. A method for manufacturing a semiconductor device, the method comprising: bonding a first wafer and a second wafer, the first wafer including a first upper detection pad and a second upper detection pad, and the second wafer including a first lower detection pad and a second lower detection pad; measuring a first current flowing between the first upper detection pad and the first lower detection pad; measuring a second current flowing between the second upper detection pad and the second lower detection pad; determining whether a first magnitude of the first current is greater than or equal to a reference magnitude; determining whether a second magnitude of the second current is greater than or equal to the reference magnitude; and determining an aligned status of the first wafer and the second wafer based on the first magnitude and the second magnitude, wherein when the first wafer and the second wafer are bonded on a plane formed by the first wafer and the second wafer, the first upper detection pad is spaced apart from the first lower detection pad by a first separation distance, and the second upper detection pad is spaced apart from the second lower detection pad by a second separation distance that is different from the first separation distance.
Clause 19. The method of Clause 18, wherein determining the aligned status of the first wafer and the second wafer comprises: determining that the first wafer and the second wafer are misaligned by the first separation distance when the first magnitude is greater than or equal to the reference magnitude and the second magnitude is less than the reference magnitude.
Clause 20. The method of Clause 18 or 19, wherein determining the aligned status of the first wafer and the second wafer comprises: determining that the first wafer and the second wafer are misaligned by the second separation distance when both the first magnitude and the second magnitude are equal to or greater than the reference magnitude.

The foregoing provides various embodiments for carrying out the present disclosure. The present disclosure will include not only the various embodiments described above, but also embodiments that can be simply changed in design or easily changed. The scope of the present disclosure will also include techniques that can be readily modified and practiced using the various embodiments. Therefore, the scope of the present disclosure should not be limited to the above-described embodiments, but should be defined by the following claims.

## Claims

1. A semiconductor device (100) comprising:
a first wafer (110) including a first upper detection pad (DP_u) and a second upper detection pad (DP_u); and
a second wafer (120) including a first lower detection pad (DP_l1) and a second lower detection pad (DP_l2),
the first wafer being (110) bonded to the second wafer (120),
when the first wafer (110) and the second wafer (120) are bonded on a plane formed by the first wafer (110) and the second wafer (120), the first upper detection pad (DP_u) and the first lower detection pad (DP_l1) are spaced apart from each other by a first separation distance (R1) on the plane, and the second upper detection pad (DP_u) and the second lower detection pad (DP_l2) are spaced apart from each other by a second separation distance on the plane (R2), the second separation distance (R2) being different from the first separation distance (R1), and
wherein an alignment status between the first wafer (110) and the second wafer (120) is determined based on a current flowing when the first upper detection pad (DP_u) and the second upper detection pad (DP_u) and the first lower detection pad (DP_l1) and the second lower detection pad (DP_12) are connected to each other.

2. The semiconductor device of claim 1,
wherein the first wafer (110) further comprises upper bonding pads (BP_u),
wherein the second wafer (120) further comprises lower bonding pads (BP_l), and
wherein when the first wafer (110) and the second wafer (120) are bonded, the upper bonding pads (BP_u) and the lower bonding pads (BP_l) are respectively electrically connected to each other on the plane.

3. The semiconductor device of claim 1 or 2,
wherein the first wafer (110) further comprises a first upper transistor (TRO) and a second upper transistor (TR0),
wherein the second wafer (120) further comprises a first lower transistor (TR1) and a second lower transistor (TR2), and
wherein one terminal of the first upper transistor (TRO) is electrically connected to the first upper detection pad (DP_u) and one terminal of the second upper transistor (TRO) is electrically connected to the second upper detection pad (DP_u), and one terminal of the first lower transistor (TR1) is electrically connected to the first lower detection pad (DP_l1) and one terminal of the second lower transistor (TR2) is electrically connected to the second lower detection pad (DP_l2).

4. The semiconductor device of claim 3,
wherein another terminal of the first upper transistor (TRO) and another terminal of the second upper transistor (TRO) are electrically connected to a power supply voltage, and
wherein another terminal of the first lower transistor (TR1) and another terminal of the second lower transistor (TR2) are electrically connected to a ground voltage.

5. The semiconductor device of any preceding claim,
wherein when the first wafer (110) and the second wafer (120) are misaligned on the plane, the first upper detection pad (DP_u) is electrically connected to the first lower detection pad (DP_l1), and the second upper detection pad (DP_u) is not electrically connected to the second lower detection pad (DP_2).

6. The semiconductor device of any preceding claim,
wherein the second wafer (120) further comprises a third lower detection pad (DP_l3) and a fourth lower detection pad (DP_l4),
wherein when the first wafer (110) and the second wafer (120) are bonded on the plane, the first upper detection pad (DP_u) is spaced apart from the third lower detection pad (DP_13) by the first separation distance (R1) on the plane, and the second upper detection pad (DP_u) is spaced apart from the fourth lower detection pad (DP_l4) by the second separation distance (R2) on the plane,
wherein the first lower detection pad (DP_l1) is disposed in a first direction from the first upper detection pad (DP_u), and
the second lower detection pad (DP_l2) is disposed in the first direction from the second upper detection pad (DP_u), and
the third lower detection pad (DP_l3) is disposed in a second direction from the first upper detection pad (DP_u), the second direction different from the first direction, and
the fourth lower detection pad (DP_l4) is disposed in the second direction from the second upper detection pad (DP_u).

7. The semiconductor device of claim 6,
wherein the first direction is orthogonal to the second direction.

8. The semiconductor device of claim 6,
wherein the first direction is opposite to the second direction.

9. The semiconductor device of claim 6,
wherein when the first wafer (110) and the second wafer (120) are misaligned on the plane, the first upper detection pad (DP_u) is electrically connected to the first lower detection pad (DP_l1), the first upper detection pad (DP_u) is not electrically connected to the third lower detection pad (DP_l3), the second upper detection pad (DP_u) is not electrically connected to the second lower detection pad (DP_l2), and the second upper detection pad (DP_u) is not electrically connected to the fourth lower detection pad (DP_l4).

10. The semiconductor device of claim 6,
wherein when the first wafer (110) and the second wafer (120) are misaligned on the plane, the first upper detection pad (DP_u) is electrically connected to the first lower detection pad (DP_l1), the first upper detection pad (DP_u) is electrically connected to the third lower detection pad (DP_l3), the second upper detection pad (DP_u) is not electrically connected to the second lower detection pad (DP_l2), and the second upper detection pad (DP_u) is not electrically connected to the fourth lower detection pad (DP_l4).

11. A method for manufacturing a semiconductor device, the method comprising:
bonding a first wafer (110) and a second wafer (120), the first wafer (110) including a first upper detection pad (DP_u) and a second upper detection pad (DP_u), and the second wafer (120) including a first lower detection pad (DP_l1) and a second lower detection pad (DP_l2);
measuring a first current flowing between the first upper detection pad (DP_u) and the first lower detection pad (DP_l1);
measuring a second current flowing between the second upper detection pad (DP_u) and the second lower detection pad (DP_l2);
determining whether a first magnitude of the first current is greater than or equal to a reference magnitude (i_REF);
determining whether a second magnitude of the second current is greater than or equal to the reference magnitude (i_REF); and
determining an aligned status of the first wafer (110) and the second wafer (120) based on the first magnitude and the second magnitude,
wherein when the first wafer (110) and the second wafer (120) are bonded on a plane formed by the first wafer (110) and the second wafer (120), the first upper detection pad (DP_u) is spaced apart from the first lower detection pad (DP_l1) by a first separation distance (R1), and the second upper detection pad (DP_u) is spaced apart from the second lower detection pad (DP_l2) by a second separation distance (R2) that is different from the first separation distance (R1).

12. The method of claim 11, wherein determining the aligned status of the first wafer (110) and the second wafer (120) comprises:
determining that the first wafer (110) and the second wafer (120) are misaligned by the first separation distance (R1) when the first magnitude is greater than or equal to the reference magnitude (i_REF) and the second magnitude is less than the reference magnitude (i_REF).

13. The method of claim 11 or 12, wherein determining the aligned status of the first wafer (110) and the second wafer (120) comprises:
determining that the first wafer (110) and the second wafer (120) are misaligned by the second separation distance (R2) when both the first magnitude and the second magnitude are equal to or greater than the reference magnitude (i_REF).

14. The method of any one of claims 11 to 13, wherein determining the aligned status of the first wafer (110) and the second wafer (120) comprises:
determining that the first wafer (110) and the second wafer (120) are aligned when the first magnitude is less than the reference magnitude (i_REF).

15. The method of any one of claims 11 to 14, wherein the first separation distance (R1) is less than the second separation distance (R2).
